(19) Europäisches Patentamt / European Patent Office / Office européen des brevets

(11) **EP 3 874 247 B1**

(12) **FASCICULE DE BREVET EUROPEEN**

(45) Date de publication et mention
de la délivrance du brevet:
**30.07.2025 Bulletin 2025/31**

(21) Numéro de dépôt: **19839384.5**

(22) Date de dépôt: **11.12.2019**

(51) Classification Internationale des Brevets (IPC):
**G01J 5/20** (2006.01)

(52) Classification Coopérative des Brevets (CPC):
**G01J 5/20**

(86) Numéro de dépôt international:
**PCT/FR2019/053017**

(87) Numéro de publication internationale:
**WO 2020/120905 (18.06.2020 Gazette 2020/25)**

(54) **PROCEDE DE FABRICATION D'UNE STRUCTURE DE DETECTION A TAUX D'ABSORPTION OPTIMISE ET LADITE STRUCTURE**

**VERFAHREN ZUR HERSTELLUNG EINER DETEKTIONSSTRUKTUR MIT OPTIMIERTER ABSORPTIONSRATE UND STRUKTUR**

**METHOD FOR MANUFACTURING A DETECTION STRUCTURE WITH AN OPTIMISED ABSORPTION RATE, AND SAID STRUCTURE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.12.2018 FR 1872785**

(43) Date de publication de la demande:
**08.09.2021 Bulletin 2021/36**

(73) Titulaire: **Commissariat à l'Energie Atomique et aux Energies Alternatives
75015 Paris (FR)**

(72) Inventeurs:
• **ALIANE, Abdelkader
  38054 GRENOBLE CEDEX 09 (FR)**
• **OUVRIER-BUFFET, Jean-Louis
  38054 GRENOBLE CEDEX 09 (FR)**

(74) Mandataire: **Brevalex
Tour Trinity
1 B Place de la Défense
92400 Courbevoie (FR)**

(56) Documents cités:
**WO-A1-2018/055276 CN-B- 103 050 412
DE-A1- 2 909 320**

## Description

Cette invention résulte d'un marché passé par le Ministère de la Défense qui dispose de certains droits dessus.

## Domaine technique

L'invention concerne les structures de détection de rayonnements électromagnétiques notamment dans le domaine des infrarouges

L'invention a ainsi plus précisément pour objet une structure de détection de rayonnements électromagnétiques et un procédé de fabrication d'une telle structure.

## État de l'art antérieur

Afin de détecter les rayonnements électromagnétiques, notamment dans la gamme de longueurs d'onde de l'infrarouge, il est connu d'utiliser des structures de détection de rayonnements électromagnétiques de type bolomètre.

Une telle structure comporte :

- un élément absorbant configuré pour absorber le rayonnement électromagnétique, généralement fourni sous la forme d'une membrane suspendue,
- un transducteur présentant une caractéristique qui varie avec la température, le transducteur étant associé à l'élément absorbant afin de permettre une détection de l'élévation de température dudit élément absorbant lors de l'absorption du rayonnement électromagnétique.

Afin d'autoriser une réduction de la taille de ces structures, il a été récemment proposé l'utilisation de transistors MOS en tant que transducteur.

Conformément au document WO2018055276 A1, le transistor d'une structure selon une telle possibilité comprend :

- au moins une première et au moins une deuxième zone d'un premier type de conductivité,
- au moins une troisième zone séparant l'une de l'autre la première et la deuxième zone, la troisième zone étant d'un deuxième type de conductivité opposé au premier type de conductivité et présente une concentration en porteurs majoritaires inférieure à celles de la première et de la deuxième zone,
- au moins une première électrode de grille agencée pour polariser la troisième zone.

Au moins une métallisation d'un tel transistor, notamment l'électrode de grille, forme l'élément absorbant de la structure de détection.

Dans cette configuration, conformément à la figure 1B du document WO2018055276 A1, les première, troisième et quatrième zones se succèdent le long du plan d'absorption afin de former respectivement le drain, le canal et la source du transistor MOS.

Si une structure de détection selon cette possibilité décrite dans le document WO2018055276 A1 permet de fournir une bonne absorption du rayonnement électromagnétique à détecter, ceci notamment par une optimisation de l'élément absorbant, cette absorption n'est toujours pas optimale.

En effet, si, conformément à son enseignement, il est possible de fournir un élément absorbant présentant une impédance proche de celle du vide, c'est-à-dire de l'ordre de 376,9 $\Omega$, l'impédance totale de la structure, qui est celle perçue par l'onde électromagnétique à absorber, est en réalité inférieure et ne permet donc pas d'obtenir une absorption optimale. Cette impédance fait en effet intervenir, en plus de l'élément absorbant, l'ensemble des éléments du transistor dont notamment les première et deuxième zones qui sont fortement dopées et les siliciurations qu'elle comporte, peuvent diminuer drastiquement l'impédance perçue par l'onde électromagnétique. De ce fait la résistance équivalente perçue par le rayonnement électromagnétique est généralement comprise entre 1 et 100 $\Omega/\square$, ce qui est relativement éloigné des 376,9 $\Omega/\square$ qui seraient nécessaire pour optimiser l'absorption du rayonnement électromagnétique par l'élément absorbant.

Des exemples supplémentaires de réalisation d'un transistor sont donnés dans les documents CN103050412 B et DE2909320.

## Exposé de l'invention

L'invention vise à remédier à cet inconvénient et a ainsi pour but de fournir un procédé de fabrication d'une structure de détection comportant un transistor MOS en tant que transducteur et qui est susceptible de présenter un taux d'absorption supérieur à une structure de l'art antérieur présentant, pour le reste de ces caractéristiques, une configuration similaire.

L'invention concerne à cet effet un procédé de fabrication d'une structure de détection de rayonnements électromagnétiques, ladite structure de détection électromagnétique comprenant un transistor MOS en tant que transducteur, procédé tel que défini dans la revendication 1.

Les inventeurs ont constaté que dans une structure telle que celle décrite dans le document WO2018055276 A1, les zones dopées, que sont les première et deuxième zones, ont un rôle prépondérant dans la baisse de l'impédance équivalente de l'élément absorbant perçue par le rayonnement. Plus précisément, cette baisse d'impédance équivalente est principalement due aux premières régions de contact surdopées des zones et à leur siliciuration.

Or, le procédé selon l'invention permet un bon contrôle des dimensions de ces dernières zones et de leurs régions surdopées, puisque ces premières régions surdopées ont leurs dimensions définies par la diffusion contrôlée d'éléments dopants implantés lors de la deuxième implantation. En effet, l'utilisation des éléments d'extension latérale en tant que masque pour à la fois le dopage à la deuxième concentration et pour la gravure de la couche semiconductrice, permet de s'assurer que la première région de chacune de la première et la deuxième zone est uniquement fournie par la diffusion des éléments dopants sous les premier et deuxième élément d'extension latérale puisque ces mêmes premières régions sont délimitées par lesdits élément d'extension latérale. Il est ainsi possible, avec le procédé selon l'invention de fournir des premières régions de la première et la deuxième zone présentant un volume minimal.

De cette manière, il est possible d'obtenir avec une structure selon l'invention une optimisation à la fois de l'absorption du rayonnement électromagnétique, ceci par une optimisation de l'impédance équivalente de l'élément absorbant qu'elle autorise, et du courant drain-source, de par l'optimisation de la longueur du canal qu'elle autorise, vis-à-vis d'une structure de l'art antérieur comportant un transistor MOS en tant que transducteur.

On notera que le transistor MOS est dans une configuration classique de l'invention un transistor MOSFET.

Par concentration en porteurs majoritaires, il est entendu, ci-dessus et dans le reste de ce document, la concentration en porteurs, parmi la concentration en trous et celle en électrons, qui est la plus importante. Ainsi, dans le cas où la concentration en porteurs majoritaires concerne une couche ou une zone réalisée dans un semiconducteur intrinsèque, la concentration en trous et en électrons étant sensiblement identique, ladite concentration en porteurs majoritaires correspond à la concentration en électrons qui est donc sensiblement identique à celle en trous.

Selon une configuration classique de l'invention, la couche semiconductrice est d'un premier type de conductivité et que le type de conductivité est d'un deuxième type de conductivité opposé au premier type de conductivité.

Bien entendu, en variante, la configuration peut être l'une de :

- la couche semiconductrice présente un premier type de conductivité et le type de conductivité est le premier type de conductivité, le transistor MOS étant alors du type N+NN+ ou P+PP+,
- la couche semiconductrice est du type intrinsèque et le type de conductivité donné est l'un parmi le type de conductivité dans lequel les porteurs majoritaires sont des électrons, c'est-à-dire d'un dopage N, et le type de conductivité dans lequel les porteurs majoritaires sont des trous, c'est-à-dire d'un dopage P, le transistor MOS étant alors du type NiN ou PiP.

Lors de l'étape de la formation d'une couche de masquage, la couche de masquage peut être réalisée dans un matériau au moins partiellement conducteur,

L'électrode de grille étant formée par la couche de masquage et l'au moins un premier matériau conducteur.

Ainsi, le procédé est particulièrement optimisé, la couche de masquage n'ayant pas à être supprimée et étant utilisée pour former l'électrode de grille.

Le matériau de la couche de masquage peut être un silicium polycristallin.

Le matériau de masquage peut être un silicium polycristallin non intentionnellement dopé, l'électrode de grille étant formée par l'au moins un premier matériau conducteur et la couche de masquage étant pourvue d'une ouverture afin d'autoriser la polarisation de l'électrode de grille.

Une telle couche de silicium polycristallin non intentionnellement dopée est particulièrement avantageuse puisqu'elle a une faible influence sur l'impédance de la première couche conductrice, celle-ci étant ainsi particulièrement adaptée pour l'absorption du rayonnement électromagnétique.

Bien entendu, le matériau de masquage peut également être dopé.

Par matériau non intentionnellement dopé, également connu sous la terminologie dopage intrinsèque, il est entendu que lors de la formation dudit matériau, il n'a pas été ajouté d'élément dopant d'un quelconque type de conductivité. Autrement dit un tel matériau non intentionnellement dopé présente une concentration en porteurs majoritaires inférieure à $1.10^{15}$ cm$^{-3}$, voire à $5.10^{14}$ cm$^{-3}$.

Le procédé de fabrication peut comporter en outre, entre l'étape de gravure localisée des parties de la couche semiconductrice et l'étape de dépôt d'au moins un deuxième matériau conducteur, une étape de siliciuration des flancs de gravure correspondant respectivement au premier et au deuxième élément d'extension latérale.

De cette manière il est possible d'avoir un contact optimisé entre le premier et le deuxième contact métallique et les première et deuxième zone, ce contact ohmique étant fourni par les couches de contact formées pendant ladite étape de siliciuration.

On notera que cette configuration bénéficie pleinement des avantages liés à l'invention, puisque ce contact optimisé ne se fait pas au détriment d'une modification de l'impédance de l'élément absorbant sur une surface importante en raison d'une présence de ces couche de contact sur des flancs de la couche semiconductrice et donc de l'orientation perpendiculaire au plan d'absorption qui en découle.

Le procédé de fabrication d'une structure de détection de rayonnements électromagnétiques peut comprendre, après l'étape de gravure sélective des parties de la couche semiconductrice, une étape de suppression de la couche de masquage.

Après l'étape gravure sélective des parties de la couche semiconductrice non protégées par l'ensemble couche de masquage/première couche conductrice et les premier et deuxième éléments d'extension latérale qui les prolongent, la couche semiconductrice peut entourer au moins en partie une zone d'un plan d'absorption défini par l'élément absorbant, l'élément absorbant s'étendant au moins en partie sur ladite zone dudit plan d'absorption.

De cette manière, l'élément absorbant présente, sur les parties s'étendant au-delà de la couche semiconductrice, une impédance équivalente non influencée par la couche semiconductrice. Il est donc aisé de fournir un élément absorbant qui présente, au moins sur ladite partie s'étendant au-delà de la couche semiconductrice, une impédance optimisé pour permettre l'absorption du rayonnement électromagnétique.

L'élément absorbant peut comprendre une couche métallique et est supporté par une couche diélectrique, le métal de la couche métallique de l'élément absorbant et les épaisseurs de ladite couche et de la couche diélectrique la supportant étant choisies de manière à respecter les inégalités suivantes : $150\,\Omega \le \rho/Ep \le 700\,\Omega$ avec $\rho$ la résistivité équivalente desdites couches et Ep la somme des épaisseurs desdites couches.

Ainsi, pour la partie s'étendant selon la zone dudit plan d'absorption, l'élément absorbant présente une impédance équivalente optimisée pour favoriser l'absorption du rayonnement électromagnétique.

L'invention concerne en outre une structure de détection de rayonnements électromagnétiques, la structure comprenant un transistor MOS en tant que transducteur, structure telle que définie dans la revendication 8.

On notera qu'une telle délimitation latérale des premières régions de la première et de la deuxième zone par les éléments d'extension latérale est obtenue avec une extrémité de chaque premier et deuxième élément d'extension latérale qui est alignée avec un flanc respectif de la couche semiconductrice selon une direction perpendicualire à un plan de la couche couche semiconductrice .

Une telle structure présente, selon le principe de l'invention, une absorption optimisée.

La structure de détection peut comprendre en outre une couche de masquage recouvrant la première couche conductrice.

Le matériau de la couche de masquage peut être un silicium polycristallin dopé, ladite couche de masquage formant avec la première couche conductrice une électrode de grille.

Une structure de détection peut être fabriquée avec un procédé de fabrication optimisé, puisque la couche de masquage n'a pas à être supprimée, celle-ci participant à la formation de l'électrode de grille.

De cette manière, la prise de contact de l'électrode de grille est facilitée.

Le matériau de la couche de masquage peut être un silicium polycristallin non intentionnellement dopé, l'électrode de grille étant formée par la première couche conductrice, et la couche de masquage étant pourvue d'une ouverture afin d'autoriser la polarisation de l'électrode de grille.

De cette manière il est possible d'avoir un contact optimisé entre le premier et le deuxième contact métallique et les première et deuxième zone, ce contact ohmique étant fourni par les couches de contact.

On notera que cette configuration bénéficie pleinement des avantages liés à l'invention, puisque ce contact optimisé ne se fait pas au détriment d'une modification de l'impédance de l'élément absorbant sur une surface importante en raison d'une présence de ces couche de contact sur des flancs de la couche semiconductrice et donc de l'orientation perpendiculaire au plan d'absorption qui en découle.

La couche semiconductrice peut entourer au moins en partie une zone d'un plan d'absorption défini par l'élément absorbant, l'élément absorbant s'étendant au moins en partie sur ladite zone dudit plan d'absorption.

Une telle partie de l'élément absorbant s'étendant sur une telle zone du plan d'absorption permet d'obtenir aisément, au niveau de ladite zone, un élément absorbant présentant une impédance équivalente optimisée pour l'absorption du rayonnement électromagnétique.

L'élément absorbant peut comprendre une couche métallique et peut être supporté par une couche diélectrique, le métal de la couche métallique de l'élément absorbant et les épaisseurs de ladite couche et de la couche diélectrique le supportant étant choisies de manière à respecter les inégalités suivantes : $150\,\Omega \le \rho/Ep \le 700\,\Omega$ avec $\rho$ la résistivité équivalente desdites couches et Ep la somme des épaisseurs desdites couches.

Ainsi, pour la partie s'étendant selon la zone dudit plan d'absorption, l'élément absorbant présente une impédance équivalente optimisé pour favoriser l'absorption du rayonnement électromagnétique.

La couche semiconductrice peut comporter sur chacun des flancs correspondant respectivement au premier et au deuxième élément d'extension latérale, une couche de contact formée d'un matériau siliciuré, ledit matériau étant préférentiellement sélectionné parmi le siliciure de nickel, le siliciure de titane, le siliciure de cobalt et le siliciure de platine.

On notera que cette configuration bénéficie pleinement des avantages liés à l'invention, puisque ce contact optimisé ne se fait pas au détriment d'une modification de l'impédance de l'élément absorbant sur une surface importante en raison d'une présence de ces couche de contact sur des flancs de la couche semiconductrice et donc de l'orientation perpendiculaire au plan d'absorption qui en découle.

**Brève description des dessins**

La présente invention sera mieux comprise à la lecture de la description d'exemples de réalisation, donnés à titre purement indicatif et nullement limitatif, en faisant référence aux dessins annexés sur lesquels :

- la figure 1 illustre une vue en coupe d'une structure de détection selon l'invention,
- la figure 2A et 2B illustrent un transistor MOS d'une structure de détection telle qu'illustrée sur la figure 1 ceci avant la formation de ses métallisations selon respectivement une vue en coupe transversale et une vue de dessus,
- les figures 3A à 3ZC illustrent, au moyen de vues en coupe transversale, les étapes préliminaires de formation d'un substrat intermédiaire pour la formation d'un transistor MOS d'une structure de détection telle qu'illustrée sur la figure 1,
- les figures 4A à 4N illustrent, au moyen de vues en coupe transversale, les étapes de formation d'un substrat de commande, d'assemblage dudit substrat de commande avec le substrat intermédiaire illustré sur la figure 3ZC et de finalisation de la structure de détection illustrée sur la figure 1,
- la figure 5 illustre, au moyen d'une vue en coupe, une étape de formation d'une première couche métallique lors de la fabrication d'une structure selon une variante de l'invention dans laquelle la première couche métallique forme l'élément absorbant.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

**Exposé détaillé de modes de réalisation particuliers**

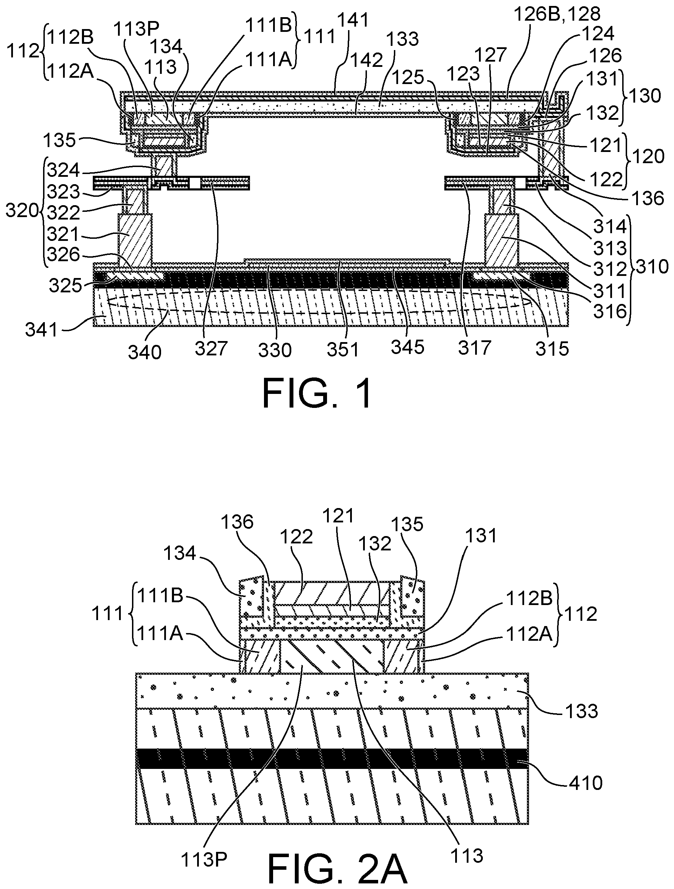

La figure 1A illustre schématiquement une structure de détection 10 de type bolomètre selon l'invention, une telle structure de détection 10 étant adaptée pour la détection d'un rayonnement électromagnétique.

Une telle structure de détection 10 vise plus particulièrement la détection de rayonnements électromagnétiques dans la gamme de longueurs d'onde des infrarouges. Ainsi, les différentes valeurs indiquées dans les modes de réalisation décrits ci-après concernent cette application pratique, dans laquelle la gamme de longueurs d'onde visée est l'infrarouge lointain, c'est-à-dire entre 8 et 12 $\mu$m. Bien entendu, ces valeurs ne sont fournies qu'à titre d'exemple non limitatif, l'homme du métier étant parfaitement à même, à partir de la présente divulgation, d'adapter ces valeurs afin de permettre à l'aide d'une telle structure de détection 10 la détection optimisée de rayonnements électromagnétiques dans une gamme de longueurs d'onde autre que celle des infrarouges.

Une telle structure de détection 10 comporte :

- un transistor 100 du type MOS associé avec l'élément absorbant 128 pour détecter l'élévation de température dudit élément absorbant 128 lors de l'absorption du rayonnement électromagnétique par ce dernier, le transistor comportant :

  o au moins une première et au moins une deuxième zone 111, 112 d'un premier type de conductivité,
  o au moins une troisième zone 113 séparant l'une de l'autre la première et la deuxième zone 111, 112, la troisième zone 113 présentant une première concentration en porteurs majoritaires inférieure à celle de la première et de la deuxième zone 111, 112, la troisième zone 113 présente un deuxième type de conductivité opposé au premier type de conductivité,
  o un oxyde de grille 130, comprenant au moins une première couche isolante 131,
  o une électrode de grille 120,
  o un premier et deuxième élément d'extension latérale 134, 135, 136 en matériau diélectrique et prolongeant au moins en partie l'électrode de grille 120,
  o un premier et un deuxième contact métallique 127, 126, 126B, de respectivement la première zone 111 et l'électrode grille 120, et la deuxième zone 112, le deuxième contact métallique 126, 126B formant un élément absorbant 128 de la structure 10, ledit élément absorbant définissant un plan d'absorption,

- un premier et un deuxième bras d'isolation thermique 310, 320 comportant respectivement une première et une deuxième piste de conduction 317, 327 pour permettre la polarisation du transistor 100, la première piste de conduction 317 étant connectée à la deuxième zone 112 au travers du deuxième contact métallique 127, la deuxième piste 327 étant connectée à la première zone 111 et l'électrode de grille 120 en les mettant en court-circuit au travers du premier contact métallique 126, 126B,
- une surface de réflexion 330, 331 optionnelle disposée de manière à former avec l'élément absorbant 128 une cavité quart-d'onde,
- un circuit de lecture 340 dont seul le substrat 341 est figuré, le circuit de lecture 340 étant connecté électriquement aux première et deuxième pistes de conduction 311, 321 par l'intermédiaire de respectivement d'une première et d'une deuxième zone de contact 315, 325.

Les première, deuxième et troisième zones 111, 112, 113 sont toutes trois aménagées dans une première couche semiconductrice 113P. Dans une configuration usuelle de l'invention, la première couche semiconductrice 113P est réalisée en silicium Si monocristallin. Bien entendu, d'autres matériaux semiconducteurs que le silicium sont envisageables pour former la première couche semiconductrice 113P ceci sans que l'on sorte du cadre de l'invention. Ainsi, en variante, la couche semiconductrice peut être réalisée en un autre matériau semiconducteur, tel que le germanium Ge et le carbure de silicium SiC, sans que l'on sorte du cadre de l'invention.

La première couche semiconductrice 113P peut présenter, par exemple une épaisseur comprise entre 10 et 500 nm, voire entre 50 et 150 nm, celle-ci pouvant être sensiblement égale à 70 nm. Comme montré sur la figure 1 et la figure 2A, la première couche semiconductrice est supportée par une quatrième couche isolante 133, la quatrième couche isolante étant une couche réalisée dans un matériau diélectrique, tel que le dioxyde de silicium et pouvant, par exemple, présenter une épaisseur comprise entre 50 et 300 nm, voire entre 100 et 200 nm et préférentiellement sensiblement égale à 145 nm.

Comme montré sur la figure 2A qui illustre une vue rapprochée en coupe d'une portion du transistor 100 en cours de fabrication, Les première, troisième et deuxième zones 111, 112, 113 se succèdent le long de la première couche semiconductrice 113P avec la troisième zone 113 qui sépare la première et la deuxième zone 111, 112. Ainsi, les première et deuxième zones 111, 112 sont agencées chacune au niveau d'un côté latéral respectif et opposé l'un à l'autre. De cette manière, les première et deuxième zones peuvent être contactées au moyen de contacts latéraux de ladite première couche semiconductrice 113P.

La troisième zone 113 présente une concentration en porteurs majoritaires inférieure à celle des première et deuxième zones 111, 112, et qui est préférentiellement significativement inférieure à celles des première et deuxième zones 111, 112, c'est-à-dire que la première concentration est préférentiellement inférieure à 10 fois à la concentration en porteurs majoritaires minimum de la première et de la deuxième zone 111, 112, voire 50 fois ou encore 100 fois à la concentration en porteurs majoritaires minimum de la première et de la deuxième zone 111, 112. Selon une application pratique, la troisième couche 113P présente un dopage P avec une concentration en porteurs majoritaires comprise entre $1.10^{14}$ et $1.10^{17}$ cm$^{-3}$, voire entre $5.10^{14}$ et $5.10^{15}$ cm$^{-3}$.

Ainsi, selon une variante de l'invention la troisième zone peut être du type semiconducteur intrinsèque, c'est-à-dire qu'elle comporte sensiblement la même concentration en électrons et en trous. Dans le cadre d'une telle variante de l'invention, le transistor MOS 100 est d'un type sélectionné parmi les transistors NiN et les transistors PiP.

Selon le principe de l'invention, la première et la deuxième zone 111, 112 comportent une première région 111A, 112A et une deuxième région 111B, 112B. Lesdites premières régions 111A, 112A présentent une concentration en porteurs majoritaires strictement supérieure à une deuxième concentration en porteurs majoritaires et lesdites deuxièmes régions 111B, 112B présentant une concentration en porteurs majoritaires égale ou inférieure à ladite deuxième concentration, ladite deuxième concentration étant supérieure à la première concentration.

Ainsi, la deuxième concentration en porteurs majoritaires peut être comprise entre $1.10^{17}$ et $1.10^{19}$ cm$^{-3}$, voire entre $5.10^{17}$ et $5.10^{18}$ cm$^{-3}$ et est, quoi qu'il en soit, supérieure à la première concentration. Selon cette possibilité, la première région 111A, 112A peut présenter une concentration en porteurs majoritaires maximale correspondant à une troisième concentration en porteurs majoritaires comprise entre $1.10^{19}$ et $1.10^{21}$ cm$^{-3}$, voire entre $5.10^{19}$ et $5.10^{20}$ cm$^{-3}$, ladite troisième concentration étant, quoi qu'il en soit, supérieure à la première concentration. Selon l'application pratique les première et deuxième zones 111, 112 présentent un dopage N.

Bien entendu, en variante, les première et deuxième zones peuvent présenter un dopage P, la troisième zone présentant alors un dopage N.

On notera qu'en variante, la première et la deuxième zone 111, 112 peuvent être du même type de conductivité que celui de la troisième zone 113. Ainsi selon cette possibilité le transistor MOS 100 est d'un type sélectionné parmi les transistors N+NN+ et les transistors P+PP+.

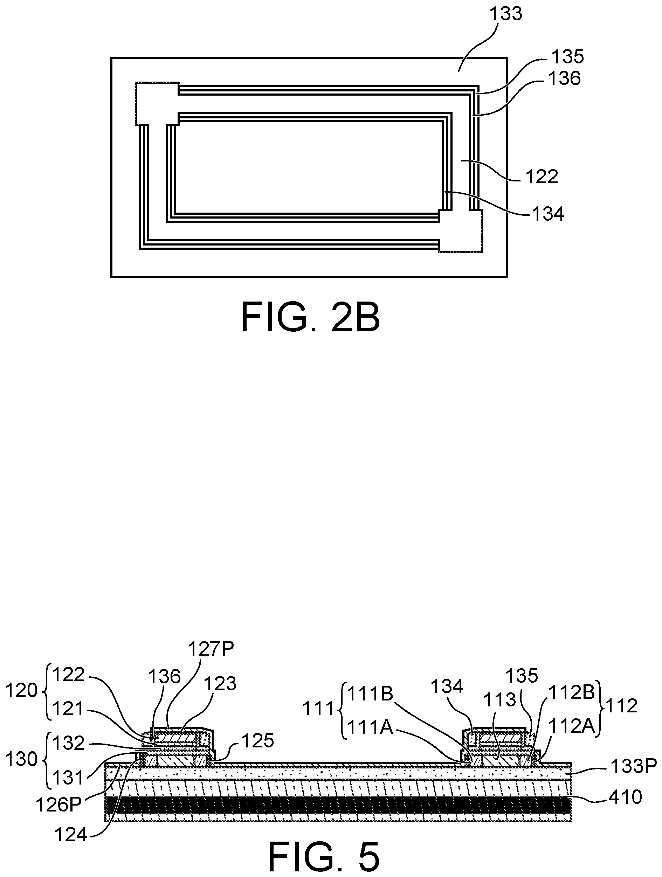

Comme illustré sur les figures 2A et 2B, la succession de la première, de la deuxième et de la troisième zone 111, 112, 113 s'étend le long d'une ligne fermée qui est, selon la possibilité illustrée sur la figure 2B, rectangulaire. Autrement dit, les première, deuxième et troisième zones 111, 112, 113 s'étendent selon des rectangles concentriques, la première zone 111 s'étendant selon un rectangle intérieur, la troisième zone 113 s'étendant selon un rectangle intermédiaire et la deuxième zone 112 s'étendant selon le rectangle externe, c'est-à-dire qu'il entoure les deux autres rectangles. Bien entendu, une telle forme n'est fournie qu'à titre d'exemple et ladite succession des première, troisième et deuxième zones 111, 113, 112 peut, bien entendu, s'étendre selon une autre forme, cette forme pouvant correspondre à une ligne ouverte ou fermée.

On notera néanmoins, que de manière préférentielle, la succession formée par les première, deuxième et troisième zones 111, 112, 113 est agencée pour entourer au moins en partie une zone du plan d'absorption. L'élément absorbant 128 s'étend au moins en partie sur ladite zone du plan d'absorption. Selon cette possibilité, la succession formée par les première, deuxième et troisième zones 111, 112, 113 peut par exemple présenter une configuration :

- en peigne, les zones du plan d'absorption entourées étant les zones disposées entre les bras du peigne, ou
- en serpentin, les zones du plan d'absorption entourées étant les zones définies entre les coudes du serpentin.

Selon une telle possibilité, comme illustré sur les figure 2A et 2B l'élément absorbant 128 s'étend selon un plan d'absorption avec une portion majoritaire, c'est-à-dire représentant plus de 50% de la surface de l'élément absorbant, de l'élément absorbant 128 qui est en dehors d'une projection de la couche semiconductrice 113P sur ledit plan d'absorption. Bien entendu, une telle portion majoritaire peut être obtenue autrement qu'avec un agencement de la succession formée par les première, deuxième et troisième zones 111, 112, 113 pour entourer au moins une zones du plan d'absorption. En effet et par exemple, une telle portion majoritaire peut être obtenue avec un élément absorbant 128 s'étendant au-delà de la succession formée par les première, deuxième et troisième zones 111, 112, 113.

La première couche semiconductrice est, comme illustré sur les figures 1 et 2A recouvertes par une deuxième couche isolante 131.

La deuxième couche isolante 131 est réalisée dans un matériau diélectrique, tel que par exemple du dioxyde de silicium $SiO_2$. La deuxième couche isolante 131 peut présenter une épaisseur comprise entre 1 et 50 nm, préférentiellement entre 2 et 25 nm.

La deuxième couche isolante 131 est recouverte par la première couche isolante 132 et par une troisième couche isolante, la troisième couche isolante 136 prolongeant latéralement la première couche isolante 132.

La première couche isolante 132 est réalisée dans un premier matériau diélectrique qui est dans un matériau diélectrique présentant un coefficient diélectrique supérieur à celui du dioxyde de silicium, ce type de diélectrique étant généralement connu sous la dénomination high-K. Ainsi, par exemple, la première couche isolante 132 peut être réalisée en dioxyde d'hafnium $HfO_2$ ou en un oxyde d'aluminium, tel que l'alumine $Al_2O_3$.

La troisième couche isolante 136 est réalisée dans un matériau diélectrique, tel qu'un dioxyde de silicium $SiO_2$.

La première couche isolante 132 est recouverte par une première couche conductrice 121.

La première couche conductrice 121 est réalisée dans un matériau conducteur. Selon une possibilité de l'invention, le matériau de la première couche conductrice 121 est préférentiellement un métal du type « milieu-de-gap » pour la troisième zone 113. Ainsi, dans le cas où la troisième zone 113 est en silicium, comme c'est le cas dans ce mode de réalisation de l'invention, le matériau de la première couche conductrice est préférentiellement un métal choisi dans le groupe comportant les nitrures de titane TiN, les nitrures de tantale TaN et les siliciures de molybdène $MoSi_2$.

On entend ci-dessus et dans le reste de ce document par « métal du type milieu-de-gap » que le métal est choisi de manière à présenter, en absence de polarisation de la structure, son énergie de Fermi dans la zone de bande interdite de la troisième zone 113 et plus précisément au voisinage du milieu de la bande interdite de la troisième zone 113, typiquement à un niveau d'énergie distant du milieu de la bande interdite dans une gamme comprise entre -25% et +25% du gap de la bande interdite. Une telle configuration de grille est généralement connue par l'homme du métier sous la dénomination anglaise de « mid-gap ». Ainsi dans le cas où la troisième zone est réalisée en silicium, les « métals du type milieu-de-gap » comportent notamment les nitrures de titane TiN, les nitrures de tantale TaN et les siliciures de molybdène $MoSi_2$.

Ainsi dans ce mode de réalisation de l'invention, la première couche conductrice 121 est préférentiellement réalisée en nitrure de titane TiN et comporte préférentiellement une épaisseur comprise entre 5 et 15 nm voire égale à 10 nm.

La première couche conductrice 121 est elle-même recouverte par une couche de masquage 122 formant selon une première possibilité de l'invention une deuxième couche conductrice.

La couche de masquage 122, dans ce mode de réalisation de l'invention, est en silicium polycristalin pSi avec une épaisseur comprise entre 10 et 150 nm préférentiellement entre 20 et 100 nm et avantageusement sensiblement égale à 50 nm.

Selon une variante particulièrement avantageuse de l'invention non illustrée, la couche de masquage 122 est réalisée en silicium polycristalin pSi non intentionnellement dopé. Selon cette variante de l'invention, la première couche conductrice forme seule l'électrode de grille et la couche de masquage présente une ouverture afin de permettre de contacter la première couche conductrice au travers de la couche de masquage 122.

Néanmoins selon le présent mode de réalisation de l'invention, et afin de favoriser la prise de contact de l'électrode de grille 120 formée par la première couche conductrice et la couche de masquage 122, la couche de masquage 122 peut être réalisée dans un silicium polycristallin pSi dopé.

Dans ce premier mode de réalisation, la première couche conductrice 121 et la couche de masquage 122 forment ensemble l'électrode de grille 120.

Les premier et les deuxième éléments d'extension latérale 134, 135, 136, également connue sous la dénomination d'espaceurs, disposés de part et d'autre de la première couche conductrice 121 et de la couche de masquage 122 et prolongeant lesdites première couches conductrice 121 et de masquage 122. Les première et deuxième éléments d'extension latérale comprennent la troisième couche isolante 136 et une première et une deuxième portion d'extension latérale 134, 135 en matériau diélectrique. Ainsi, le matériau de chacune des premier et deuxième portions d'extension latérale 134, 135 peut être sélectionné parmi le dioxyde de silicium $SiO_2$ et le nitrure de silicium SiN.

Chacun desdits premier et deuxième éléments d'extension latérale recouvrent au moins en partie les premières régions de la première et de la deuxième zone 111, 112 en les délimitant latéralement. Ainsi les première et deuxième éléments d'extension latérale 134, 135, 136 délimitent latéralement et respectivement les première régions 111A, 112A des première et deuxième zones 111, 112. Plus précisément, une telle délimitation latérale est fournie par un alignement d'une extrémité de chaque premier et deuxième élément d'extension latérale 134, 135, 136 avec un flanc respectif de la couche semiconductrice 113P selon une direction perpendicualire à un plan de la couche semiconductrice 113P.

Chacune de la première et de la deuxième zone 111, 112 et la deuxième couche de masquage 122 présente respectivement une première, deuxième et troisième couche de contact 125, 124, 123. Chacune de la première, deuxième et troisième couche de contact 125, 124, 123 est formée d'un matériau siliciuré, ledit matériau étant sélectionné parmi le siliciure de nickel NiSi, le siliciure de titane TiSi, le siliciure de cobalt CoSi et le siliciure de platine PtSi.

La première et la troisième couche de contact 125, 123 sont toutes deux en contact avec le premier contact métallique 127, la deuxième couche de contact 124 étant en contact du deuxième contact métallique 126, 126B.

Le premier contact métallique comprend une première couche métallique 127 recouvrant les deuxième et troisième couches de contact 124, 123 et le deuxième élément d'extension latérale 135, 136.

Le deuxième contact métallique 126, 126B comprend une deuxième couche métallique 126, et une troisième couche métallique 126B. La deuxième couche métallique 126 est en contact avec la première couche de contact 125 et avec le premier bras d'isolation thermique 310 et la première piste de conduction 311 qu'il comporte. La troisième couche métallique 126B recouvre la quatrième couche d'isolation 133 sur une face de cette dernière qui est opposée à la première couche semiconductrice. La troisième couche métallique forme l'élément absorbant 128 de la structure 10.

Les première, deuxième et troisième couches métalliques 127, 126, 126B peuvent être réalisées en nitrure de titane TiN.

Suivant l'enseignement du document WO2018055276 A1 et en prenant en compte la configuration de l'élément absorbant 128, de manière à favoriser les capacités d'absorption de l'élément absorbant 128, la troisième couche métallique 126B et la troisième couche d'isolant 133 qui la supporte sont choisies de manière à respecter les inégalités suivantes :

$$150 \Omega \leq \frac{\rho}{Ep} \leq 700 \ \Omega$$

avec $\rho$ la résistivité équivalente de la première couche conductrice 121 et de la troisième couche d'isolant 133 et Ep étant la somme de l'épaisseur de la première couche conductrice 121 et de la troisième couche d'isolant 133.la. On notera, que de manière encore plus préférentielle $\rho/E_p$ est choisi proche, voire égale à 376,9 $\Omega$.

La troisième couche métallique 126B est ainsi préférentiellement réalisée en nitrure de titane TiN et comporte préférentiellement une épaisseur comprise entre 5 et 15 nm voire égale à 10 nm.

On notera que dans la configuration ci-dessus, la troisième couche d'isolant 133 n'a pas ou peu d'influence sur l'impédance équivalente de l'ensemble , la troisième couche métallique 126B et la troisième couche d'isolant 133, ce qui explique les valeurs identique pour l'épaisseur de la troisième couche métallique 126B à celle enseignée dans le document WO2018055276.

Les première et deuxième couches métalliques 127, 126 présentent préférentiellement une configuration similaire à celle de la troisième couche métallique 126B et sont donc préférentiellement réalisées en nitrure de titane TiN et comporte préférentiellement une épaisseur comprise entre 5 et 15 nm voire égale à 10 nm.

La troisième couche métallique 126B est recouverte d'une première couche de protection 141 adaptée pour protéger la troisième couche métallique lors d'une attaque sélective, telle qu'une attaque à l'acide fluorhydrique HF en phase vapeur, d'un matériau sacrificielle 431, 432, 431, tel que du dioxyde de silicium. Ainsi la première couche de protection 141 peut par exemple être une couche d'alumine $Al_2O_3$, de nitrure d'aluminium AIN ou encore de dioxyde d'hafnium $HfO_2$.

De la même façon, les première, deuxième couches métalliques 127, 126 et la quatrième couche d'isolation 133 sont recouvertes d'une deuxième couche de protection 142 adaptée pour protéger la troisième couche métallique lors d'une attaque sélective, telle qu'une attaque à l'acide fluorhydrique HF en phase vapeur, d'un matériau sacrificiel 431, 432, 431, tel que du dioxyde de silicium. Ainsi la deuxième couche de protection 142 peut par exemple être une couche d'alumine $Al_2O_3$, de nitrure d'aluminium AIN ou encore de dioxyde d'hafnium $HfO_2$. Chacune de la première et de la deuxième couche de protection 143, 141 peut présenter une épaisseur comprise entre 10 et 50 nm et préférentiellement égale à 25 nm.

La deuxième couche de protection 142 présente une première et une deuxième ouverture par lesquelles les première et deuxième couches métalliques 127, 126 sont en contact avec respectivement les pistes de conduction 317, 327 du premier et du deuxième bras d'isolation 310, 320.

Le premier bras d'isolation 310 comprend :

- une première interconnexion verticale 314 dont une première extrémité est en contact avec la première couche métallique 127,
- un premier ruban d'isolation 323 configuré avec une longueur optimisée sans empiètement sur la cavité quart-d'onde, le premier ruban d'isolation 323 présentant une première extrémité en contact avec la première interconnexion verticale 314 sur une deuxième extrémité de la première interconnexion verticale 314 qui est opposée à la deuxième extrémité,

- un troisième plot de connexion électrique 312 en contact avec le premier ruban d'isolation sur une deuxième extrémité du premier ruban et étant adapté pour permettre le collage avec un premier plot de connexion électrique 311,
- le premier plot de connexion électrique 311 collé au troisième plot de connexion électrique 312, par exemple par collage moléculaire,
- un troisième contact métallique 316 supportant le premier plot de connexion électrique 311 à l'opposé du troisième plot de connexion électrique 312.

D'une manière identique, le deuxième bras d'isolation 320 comprend :

- une deuxième interconnexion verticale 324 dont une première extrémité est en contact avec la deuxième couche métallique 126,
- un deuxième ruban d'isolation 323 configuré avec une longueur optimisée sans empiètement sur la cavité quart-d'onde, le deuxième ruban d'isolation 323 présentant une première extrémité en contact avec la deuxième interconnexion verticale 324 sur une deuxième extrémité de la deuxième interconnexion verticale 324 qui est opposée à la deuxième extrémité,
- un quatrième plot de connexion électrique 322 en contact avec le deuxième ruban d'isolation sur une deuxième extrémité du deuxième ruban et étant adapté pour permettre le collage avec un deuxième plot de connexion électrique 321,
- le deuxième plot de connexion électrique 321 collé au quatrième plot de connexion électrique 322, par exemple par collage moléculaire,
- un quatrième contact métallique 326 supportant le deuxième plot de connexion électrique 321 à l'opposé du quatrième plot de connexion électrique 322.

Comme illustré sur la figure 1, la première et la deuxième interconnexion 314, 324 peuvent chacune comporter un corps métallique réalisé, par exemple, en tungstène W et une troisième couche de protection recouvrant le corps métallique, ladite troisième couche de protection pouvant être formée d'une couche de titane Ti et d'une couche de nitrure de titane TiN.

Le premier et le deuxième ruban d'isolation 313, 323 s'étend selon un plan d'isolation parallèle au plan d'absorption et présente une forme apte à fournir une longueur optimisée ceci afin d'optimiser l'isolation thermique du transistor 100 vis-à-vis du substrat 201. Ainsi par exemple, le premier et le deuxième ruban d'isolation 313, 323 peuvent chacun présenter une forme en zigzag ou encore en spirale. Le premier et le deuxième ruban d'isolation comprennent chacun : une piste centrale métallique, par exemple, en nitrure de titane TiN, et un revêtement de passivation et de protection par exemple formé d'un empilement d'une couche en silicium amorphe aSi, une couche en dioxyde d'hafnium $HfO_2$ et une couche d'alumine $Al_2O_3$, ou nitrure d'Aluminium AlN ou en nitrure de silicium SiN.

Le troisième et le quatrième plot de connexion électrique 312, 322 comprennent chacun un cœur métallique et un revêtement barrière par exemple en nitrure de titane TiN. Le métal de chacun des cœurs métalliques du troisième et du quatrième plot de connexion électrique est adapté pour permettre un collage à respectivement le premier et le deuxième plot métallique, ce métal étant préférentiellement du cuivre Cu. La partie de chacun du troisième et du quatrième plot de connexion électrique 313, 323 par laquelle lesdits troisième et quatrième plots de connexion électrique 313, 323 sont collés à respectivement le premier et le deuxième plots de connexion électriques 312, 322 est exempt de revêtement barrière.

Le premier et le deuxième plot de connexion électrique 311, 321, afin de permettre le collage, tel qu'un collage moléculaire, sont respectivement formés dans un métal préférentiellement identique à celui du cœur métallique du troisième et du quatrième plot de connexion électrique 312, 322. Ainsi, le premier et le deuxième plot 311, 321 de connexion électrique sont préférentiellement du cuivre Cu.

Le troisième et le quatrième contact métallique 316, 326 sont adaptés pour former un contact ohmique avec respectivement la première et la deuxième zone de contact 315, 325. Ainsi, le troisième et le quatrième contact métallique 316, 326 peut être réalisé dans un matériau métallique sélectionné parmi l'aluminium Al, le cuivre Cu, l'or Au, le titane Ti, le platine Pt, le nickel et leurs alliages dont notamment l'alliage d'aluminium cuivre AlCu. L'épaisseur du troisième et du quatrième contact métallique 316, 326 peut être comprise entre 100 nm et 1 $\mu$m et préférentiellement sensiblement égal à 300 nm.

Le troisième contact métallique 316, le premier plot de connexion électrique 311, le cœur métallique du troisième plot de contact 312, la piste centrale métallique du ruban d'isolation 313, et le corps métallique de la première interconnexion verticale 314 forment ensemble la première piste de conduction 317.

D'une manière similaire, le quatrième contact métallique 326, le deuxième plot de connexion électrique 321, le cœur métallique du quatrième plot de contact 322, la piste centrale métallique du deuxième ruban d'isolation 323, et le corps métallique de la deuxième interconnexion verticale 324 forment ensemble la deuxième piste de conduction 327.

La première et la deuxième piste de conduction 317, 327 permettent de connecter les première et deuxième zones de contact 315, 325 du circuit de lecture 340 avec le transistor MOS 100.

Ainsi, le substrat 341 comprend le circuit de lecture 340 et présente une première et une deuxième zone de contact du circuit de lecture 315, 325 et une surface de réflexion 330 agencée pour former avec l'élément absorbant 128 formé par la troisième couche de conduction 126B la cavité quart d'onde adaptée à la plage de longueurs d'onde du rayonnement détecté par la structure de détection 10. La surface de réflexion 330 présente une configuration similaire à celle du troisième et du quatrième contact métallique est préférentiellement formée dans un matériau sélectionné dans le groupe comportant l'aluminium Al, le cuivre Cu, l'or Au, le titane Ti, le platine Pt, le nickel Ni et leurs alliages dont notamment l'alliage de cuivre et d'aluminium. La surface de réflexion 330 présente une épaisseur comprise entre 100 nm et 1 $\mu$m, celle-ci étant préférentiellement égale à 300 nm. On notera que le substrat 410 présente également une quatrième couche isolante 345 recouvrant une première face du substrat et s'interposant entre le substrat et la troisième couche isolante.

De manière identique à la troisième couche métallique 126B, en raison du procédé de fabrication préféré de l'invention, dans ce premier mode de réalisation, la surface de réflexion 330 est revêtue, sur sa face qui est opposée au substrat, d'une quatrième couche de protection 351, telle qu'une couche en nitrure d'aluminium AIN, de dioxyde d'hafnium HfO$_2$ ou de saphir Al$_2$O$_3$, apte à protéger la surface de réflexion lors d'une attaque acide telle qu'une attaque à l'acide fluorhydrique HF. La quatrième couche de protection 351 présente une épaisseur comprise entre 10 et 200 nm, voire entre 20 et 150 nm, et préférentiellement égale à 100 nm.

Une telle structure de détection 10 peut être fabriquée au moyen d'un procédé de fabrication présentant trois phases différentes :

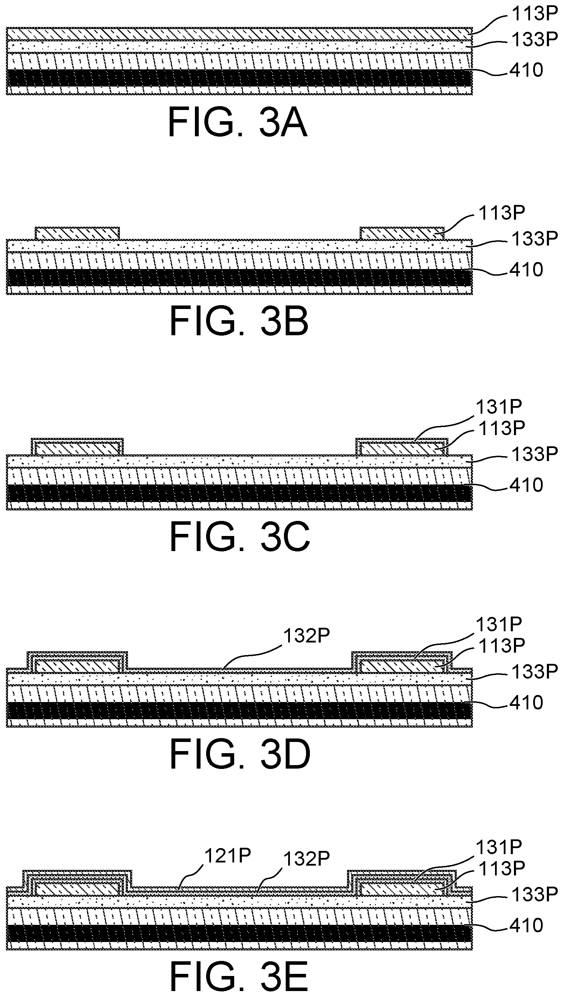

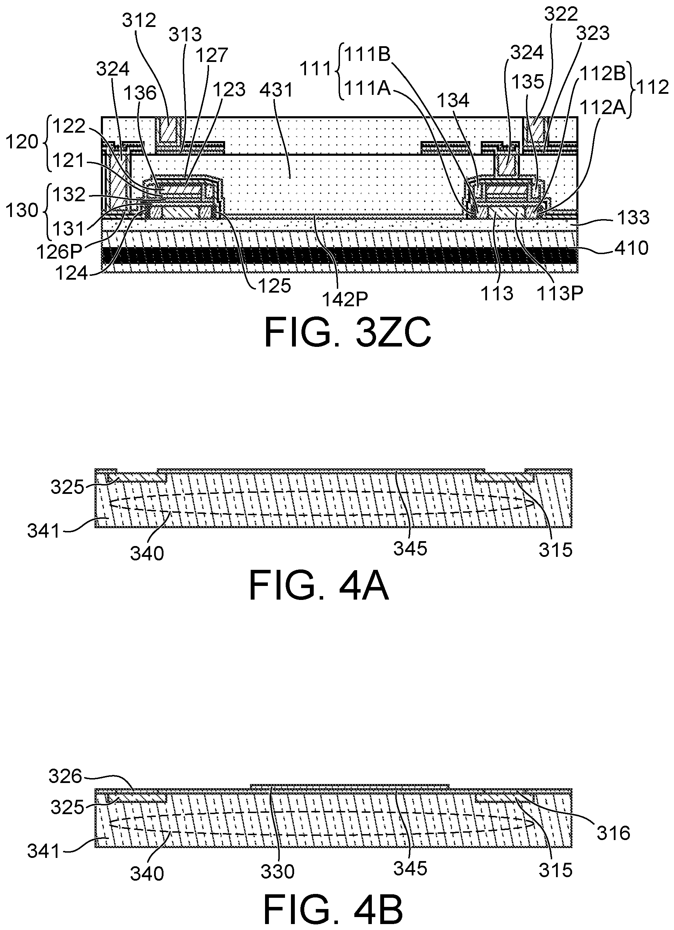

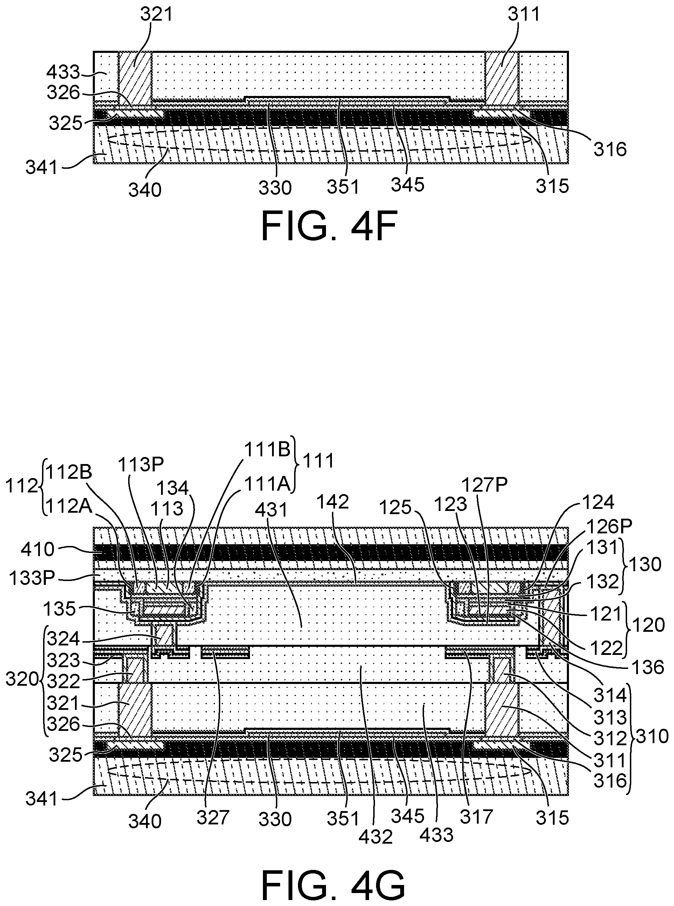

- une première phase de fabrication des principales parties du transistor 100, les étapes correspondant à cette première phase étant illustrées sur les figures 3A à 3ZC,
- une deuxième phase de fabrication du substrat comportant le circuit de lecture 340, les étapes correspondant à la deuxième phase étant illustrées sur les figures 4A à 4F,
- une troisième phase d'assemblage du substrat 341 comportant le circuit de lecture et du transistor 100 et de finalisation de la structure de détection 10, les étapes correspondant à la troisième phase étant illustrées sur les figures 4G à 4N.

Ainsi, comme illustré sur les figures 3A à L, la première phase du procédé de fabrication comprend les étapes suivantes :

- fourniture d'un premier substrat 410 comprenant une couche semiconductrice sur isolant, ladite couche semiconductrice formant la première couche semiconductrice 113P selon l'invention et l'isolant étant formé par une quatrième couche isolante 133P, tel qu'un substrat silicium sur isolant plus connu sous le sigle anglais SOI, comme illustré sur la figure 3A,

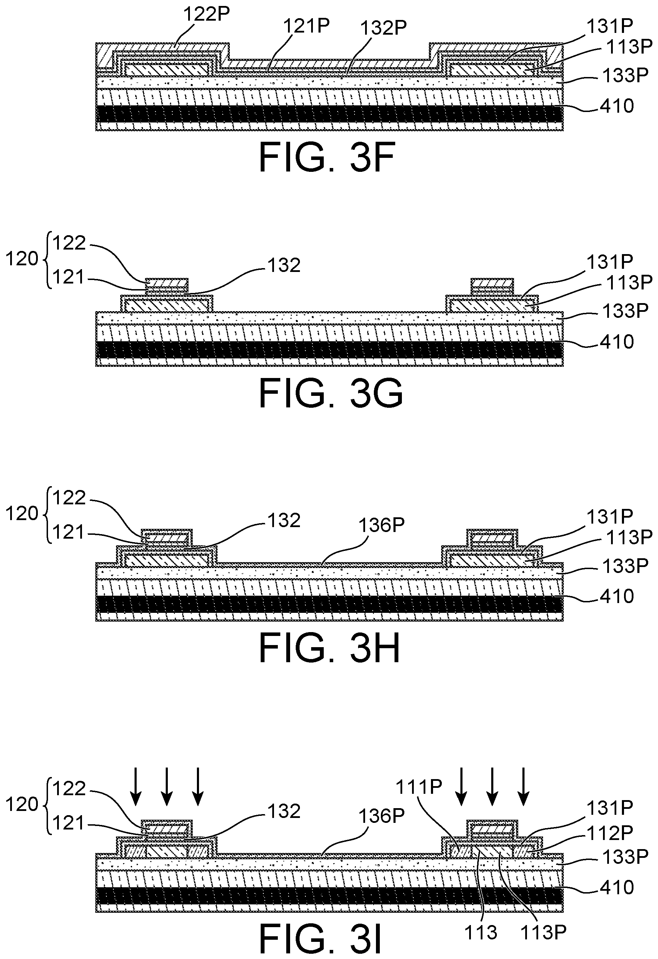

- gravure localisée de la première couche semiconductrice 113P de manière à garder uniquement les parties de la première couche semiconductrice 113P destinées à former les première, troisième et quatrième zones 111, 113, 112, comme illustré sur la figure 3B,
- oxydation partielle de la première couche semiconductrice 113P pour former la première couche isolante 131P en dioxyde de silicium en contact de ladite première couche semiconductrice 113P, comme illustré sur la figure 3C,
- dépôt d'un matériau diélectrique présentant une constante diélectrique supérieure à celui du dioxyde de silicium SiO$_2$ en contact avec la première couche isolante 131P et de la quatrième couche isolante 133P ceci de manière à former la deuxième couche isolante 132P, comme illustré sur la figure 3D,
- dépôt d'un premier matériau conducteur à la surface de la deuxième couche isolante 132P pour former une première couche conductrice 121P, la première couche conductrice 121P, ledit premier matériau conducteur étant pour le présent mode de réalisation du nitrure de titane TiN avec une épaisseur comprise entre 5 et 15 nm, préférentiellement égale à 10 nm, comme illustré sur la figure 3E,
- dépôt d'un deuxième matériau conducteur en contact de la première couche conductrice 122P ceci de manière à former la couche de masquage 122P, ledit deuxième matériau conducteur étant pour le présent mode de réalisation du silicium polycristalin pSi déposé par un dépôt chimique en phase vapeur avec une épaisseur comprise entre 10 et 150 nm, préférentiellement entre 20 et 100 nm et avantageusement sensiblement égale à 50 nm, ladite couche de masquage 122P formant une couche de masquage, comme illustré sur le figure 3F,
- gravure localisée de la deuxième et de la première couche conductrice 122P, 121P et de la deuxième couche isolante 132P afin de former un ensemble couche de masquage/première couche conductrice, la première couche conductrice et la couche de masquage formant l'électrode de grille 120 du transistor MOS 100, comme illustré sur la figure 3G,
- dépôt d'une première couche de pré-implantation 136P réalisée en dioxyde de silicium SiO$_2$ en contact des surfaces exposées de la quatrième couche d'isolation 133P, de la première couche isolante 131P, de la deuxième couche isolante 132, et la première couche conductrice 121 et de la couche de masquage 122, ladite première couche de pré-implantation 136P formant la troisième couche isolante, comme illustré sur la figure 3H,
- première implantation en éléments dopants de la couche semiconductrice 113P, une première partie de la couche semiconductrice 113P étant protégée par l'ensemble couche de masquage/première couche conductrice, et ladite implantation étant réalisée avec une première dose adaptée pour fournir la deuxième concentration en porteurs majoritaires supérieure à la première concentration, lesdits éléments dopants étant aptes à fournir des porteurs majoritaires du deuxième type de conductivité opposé au premier type de conductivité, comme illustré sur la figure 3I,

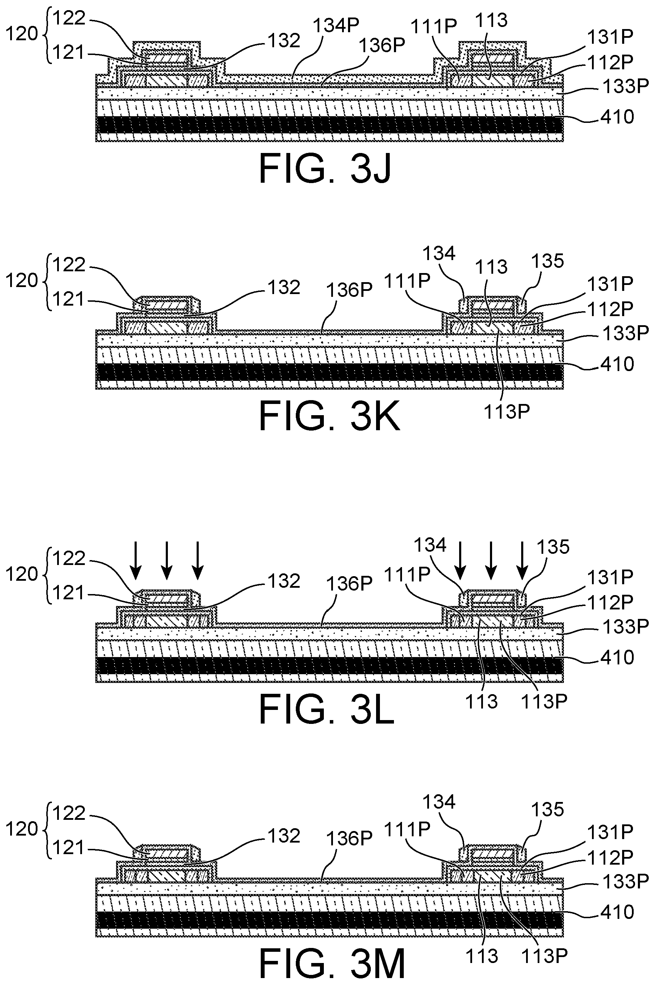

- dépôt d'une couche de matériau diélectrique 134P en contact la troisième couche isolante 136P, ledit matériau diélectrique étant préférentiellement sélectionné parmi le dioxyde de silicium $SiO_2$ et un nitrure de silicium $Si_3N_4$, ladite couche pouvant présenter une épaisseur comprise entre 20 et 500 nm préférentiellement entre 30 et 200 nm, comme illustré sur la figure 3J,

- gravure physique anisotrope de la couche de matériau diélectrique 134P, telle qu'une gravure ionique réactive ou par plasma, de manière à ne conserver que les parties de la couche diélectrique qui sont en regard avec les flancs de l'empilement formés par la deuxième couche isolante 132, la première couche conductrice 121 et la couche de masquage 122, les parties restantes de la couche de matériau diélectrique 134P formant les première et deuxième portions d'extension latérale 134, 135, cette gravure permettant la formation du premier et du deuxième élément d'extension latérale 134,135, 136 réalisés dans les matériaux diélectriques de la quatrième couche d'isolation 136 et des première et deuxième portions d'extension latérale 134, 136 en contact avec la première couche isolante 131P de part et d'autre de l'ensemble première couche conductrice 121/ couche de masquage 122, lesdits premier et deuxième éléments d'extension latérale 134, 135, 136 prolongeant l'ensemble première couche conductrice 121/ couche de masquage 122, comme illustré sur la figure 3K,

- deuxième implantation en éléments dopants de la première couche semiconductrice 113P, une deuxième partie de la première couche semiconductrice 113P, comprenant la première partie de la première couche semiconductrice 113P, étant protégée par l'ensemble première couche conductrice 121/ couche de masquage 122 et premier et deuxième élément d'extension latérale 134, 135, 136 qui les prolongent, ladite deuxième implantation étant réalisée avec une deuxième dose supérieure à la première dose et étant adaptée pour fournir une troisième concentration en porteurs majoritaires supérieure à la deuxième concentration, lesdits éléments dopants étant aptes à fournir des porteurs majoritaires du deuxième type de conductivité, comme illustré sur la figure 3L,

- recuit thermique du premier substrat 410 avec notamment la première couche semiconductrice 113P, le recuit thermique étant apte à faire diffuser et à activer les éléments dopants implantés lors de la première et de la deuxième implantation, ceci de manière à former la première et la deuxième zone 111P, 112P du transistor avec pour chacune de la première et de la deuxième zone 111P, 112P une première région présentant une concentration en porteurs majoritaires strictement supérieure à la deuxième concentration et une deuxième région présentant une concentration en porteurs majoritaires égale ou inférieure à la deuxième concentration, ladite première région étant respectivement en partie recouverte par les premier et deuxième éléments d'extension latérale 134, 135, 136, lesdites première et deuxième zones 111P, 112P étant séparées l'une de l'autre par une troisième zone 113 du transistor MOS 100 recouverte par la première couche isolante 131P, le recuit thermique pouvant être par exemple un recuit à une température entre 950°C et 1050°C pendant une durée comprise entre 1 et 20s, comme illustré sur la figure 3M,

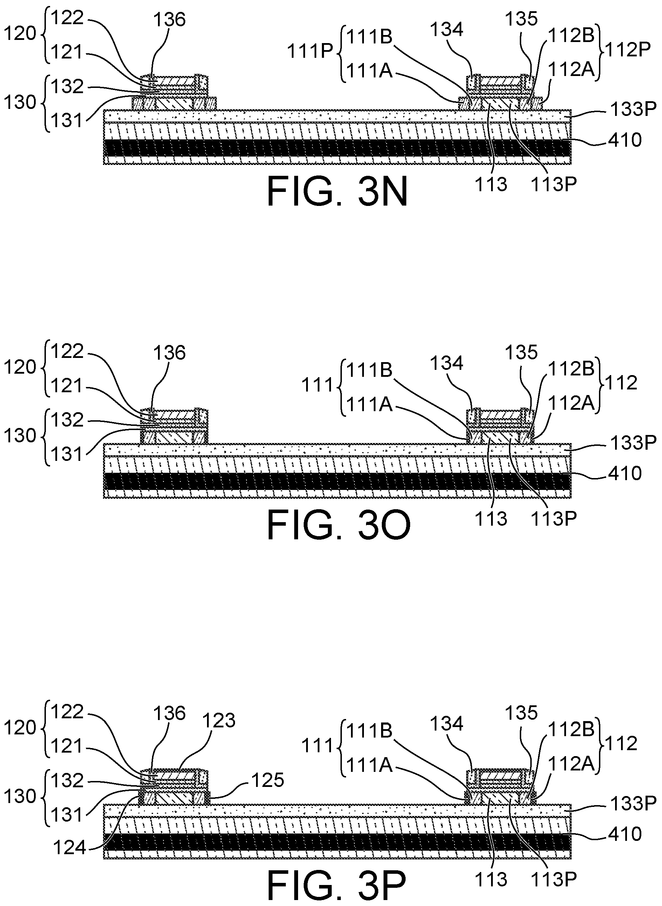

- gravure localisé, par exemple par une gravure sélective du dioxyde de silicium $SiO_2$ par rapport au silicium Si at au nitrure de silicium SiN, telle qu'une gravure chimique adaptée pour graver sélectivement le dioxyde de silicium $SiO_2$, des parties exposées de la quatrième couche isolante 136, comme illustré sur la figure 3N,

- gravure localisé, ceci par exemple au moyen d'une gravure sélective du dioxyde de silicium $SiO_2$ vis-à-vis du nitrure de silicium SiN, des parties de la première couche semiconductrice 113P non protégées par l'ensemble première couche conductrice 121/ couche de masquage 122 et premier et deuxième élément d'extension latérale 134, 135, 136, ladite gravure sélective permettant de conserver uniquement les parties des premières régions 111A, 112A de chacune de la première et de la deuxième zone 111, 112 protégées par la première et la deuxième extension latérale 134, 135, 136 et, le cas échéant, par l'ensemble couche de masquage/ première couche conductrice, la première et la deuxième zone 111, 112 du transistor MOS 100 étant ainsi formées avec pour chacune d'entre elle, la formation des première et deuxième régions 111A, 112A, 111B, 112B, ainsi une extrémité de chaque premier et deuxième élément d'extension latérale 134, 135, 136 est alignée avec un flanc respectif de la couche semiconductrice 113P selon une direction perpendicualire à un plan de la couche couche semiconductrice 113P ,comme illustré sur la figure 3O,

- siliciuration des première et deuxième zones 111, 112 au niveau des flancs de la première couche semiconductrice et de la surface de la couche de masquage 122 pour former respectivement les première, deuxième et troisième couches de contact 125, 124, 123, la siliciuration étant fournie, par exemple, par un dépôt successif de nickel Ni et d'un nitrure de titane TiN suivi d'un recuit entre 300 et 350°C et une gravure sélective adaptée pour graver le nickel Ni et le nitrure de titane TiN n'ayant pas réagi, ladite siliciuration, pouvant être adaptée, en variante, pour former chacune des première, deuxième et troisième couches de contact 125, 124, 123 en un siliciure préférentiellement sélectionné parmi le siliciure de nickel NiSi, un siliciure de titane TiSi, un siliciure de cobalt CoSi et un siliciure de platine PtSi, comme illustré sur la figure 3P,

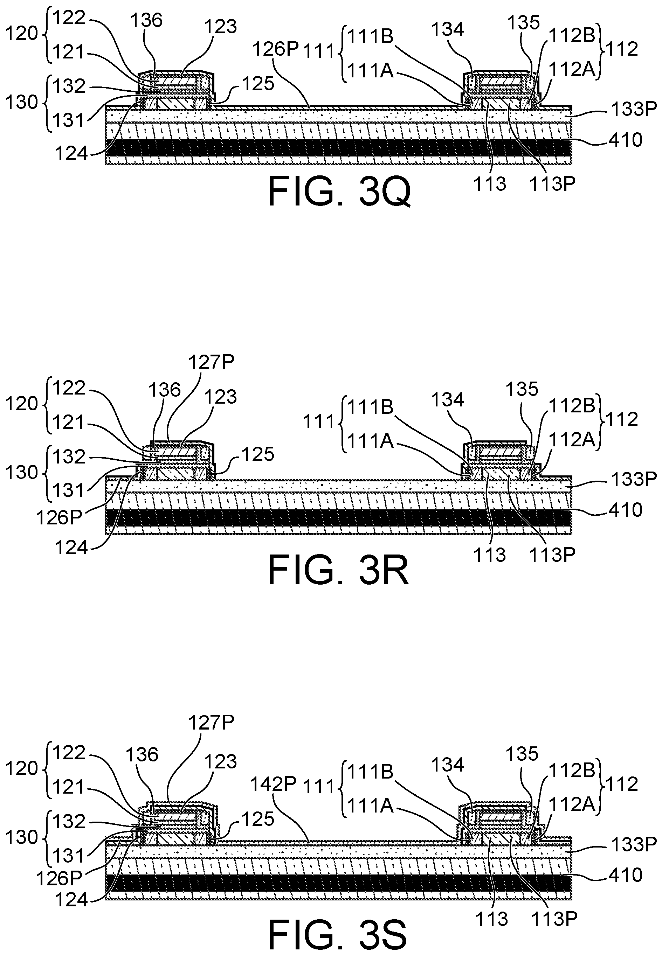

- dépôt d'une couche métallique 126P en contact de la troisième couche isolante 133P et des première, deuxième et troisième couches de contact 125, 124, 123, ladite couche métallique 126P étant destinée à la formation des première et deuxième couches métalliques 127, 126, ladite couche métallique 126P étant préférentiellement réalisée en nitrure de titane TiN et comportant préférentiellement une épaisseur comprise entre 5 et 15 nm voire égale à 10 nm, comme illustré sur la figure 3Q,

- gravure localisée de la couche métallique 126P de manière à former la première couche métallique 127P en contact avec la première et la troisième couche de contact 124, 123 et la deuxième couche de contact 126P en contact avec la première couche de contact 125, la troisième couche isolante 133P étant libérée de couche métallique 126P, comme illustré sur la figure 3R,

- dépôt de la deuxième couche de protection 142 en contact des première et deuxième couches métalliques 127P, 126P et de la troisième couche isolante 133P, la deuxième couche de protection pouvant être une couche d'alumine $Al_2O_3$, de nitrure d'aluminium AIN ou encore de dioxyde d'hafnium $HfO_2$, avec une épaisseur comprise entre 10 et 50 nm et préférentiellement égale à 25 nm, comme illustré sur figure 3S,

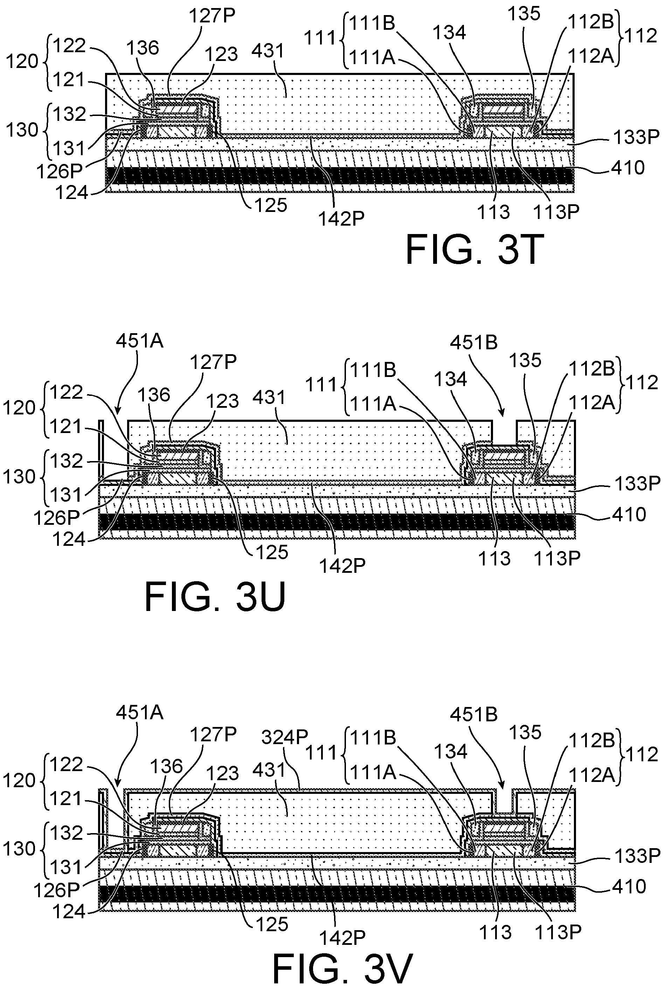

- dépôt d'une première couche de matériau sacrificiel 431, telle qu'une couche de dioxyde de silicium $SiO_2$, en contact avec la deuxième couche de protection 142 et planarisation de ladite première couche de matériau sacrificielle 431 pour supprimer l'excès de matériau sacrificiel ceci de manière à encapsuler l'ensemble première, deuxième et troisième zone/ première et deuxième couche isolante/ première couche conductrice/couche de masquage / deuxième couche de protection, comme illustré sur la figure 3T,

- gravure localisée de la première couche de matériau sacrificiel 431 pour former deux percées 451A, 451B débouchant respectivement sur la première et la deuxième couche métallique 127, 126B, comme illustré sur la figure 3U,

- dépôt d'une troisième couche de protection 324P en contact de la première couche de matériau sacrificiel 431 et des parois des deux percées 451A, 451B aménagées dans la première couche de matériau sacrificiel 431 et notamment en contact des première et deuxième couches métalliques 127, 126, ladite troisième couche de protection 324P comprenant une sous-couche de titane Ti et une sous-couche de nitrure de titane TiN, comme illustré sur la figure 3V,

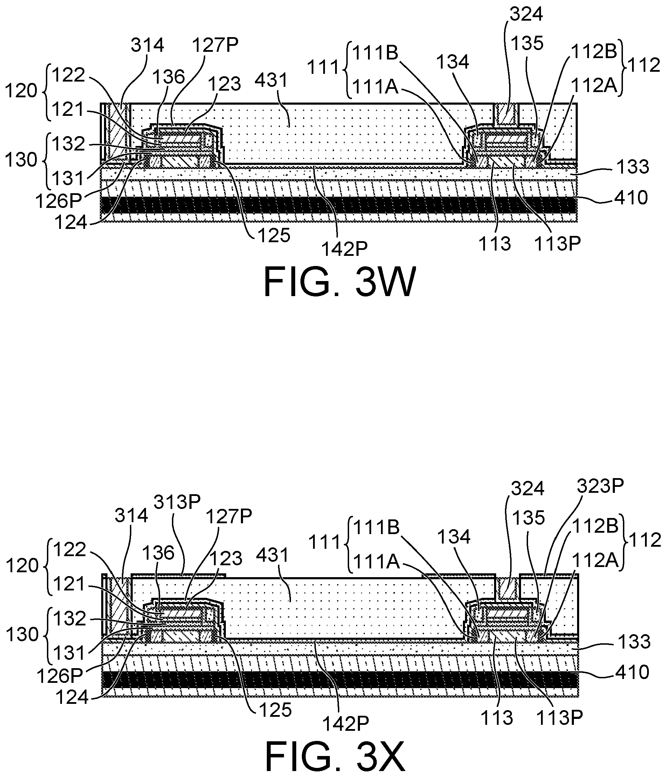

- dépôt du matériau formant le corps métallique des interconnexions verticales 314, 324 de manière à remplir les deux percées 451A, 451B aménagées dans la première couche de matériau sacrificiel 431 et de former la première et la deuxième interconnexions verticales, comme illustré sur la figure 3W,

- dépôt localisé d'une première partie du revêtement de passivation et de protection du premier et du deuxième ruban d'isolation 313, 323 en contact avec la première couche de matériau sacrificiel 431, ladite première partie du revêtement de passivation et de protection pouvant comprendre une sous-couche de silicium amorphe aSi, une sous-couche d dioxyde d'hafnium $HfO_2$ et une sous-couche d'alumine $Al_2O_3$ comme illustré sur la figure 3X,

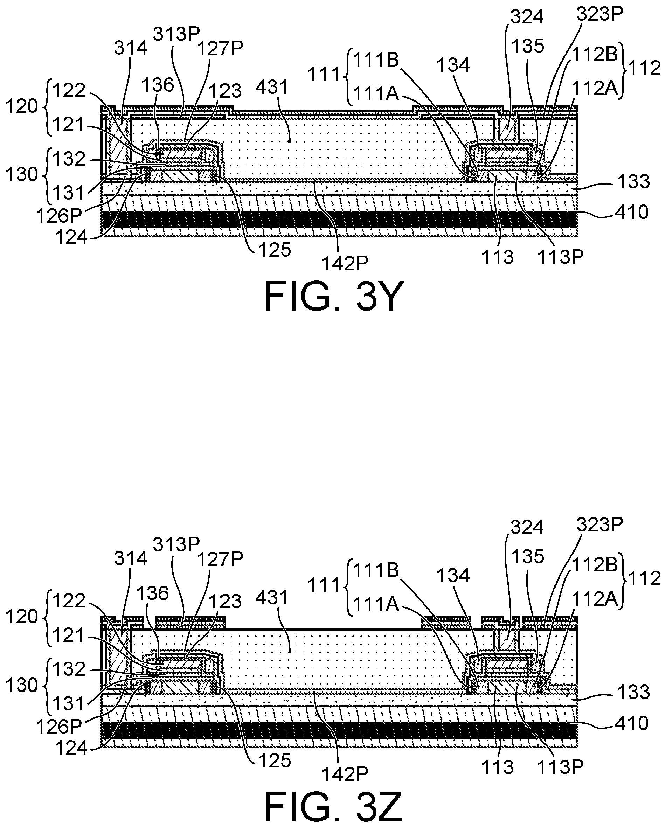

- dépôt d'une couche métallique destinée à former la piste centrale métallique des premier et deuxième rubans d'isolation 313, 323 et de la première couche de matériau sacrificiel 431, dépôt, en contact de ladite couche métallique, d'une couche destinée à former la deuxième partie du revêtement de passivation et de protection du premier et du deuxième ruban d'isolation 313, 323, comme illustré sur la figure 3Y,

- suppression des portions de ladite couche métallique et de ladite couche destinée à former la deuxième partie du revêtement de passivation et de protection du premier et du deuxième ruban d'isolation 313, 323 de manière à former le premier et le deuxième ruban d'isolation 313, 312, comme illustré sur la figure 3Z,

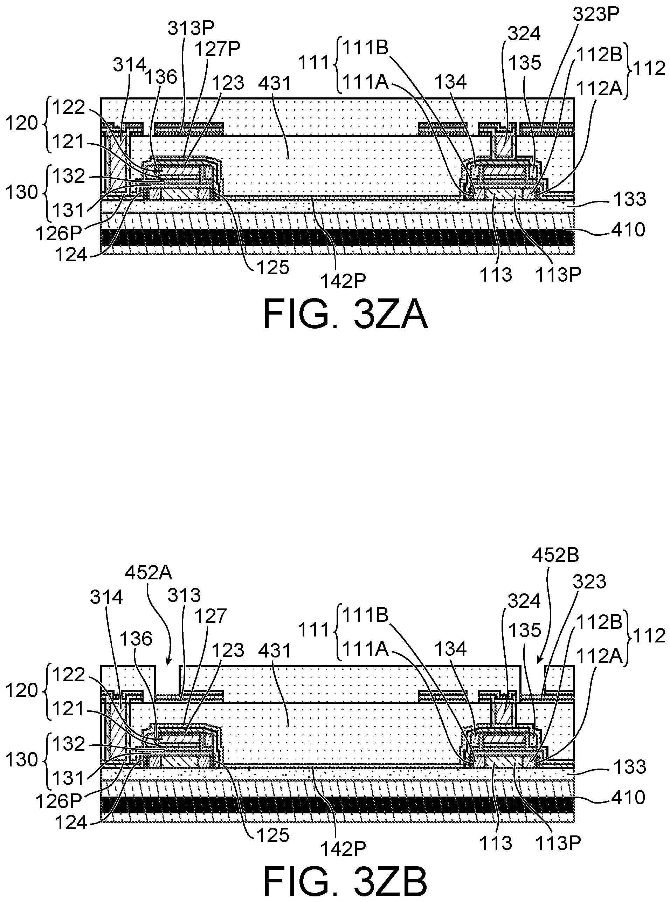

- dépôt d'une deuxième couche de matériau sacrificiel 432, telle qu'une couche de dioxyde de silicium $SiO_2$, en contact avec les premier et deuxième rubans d'isolation 313, 323 et de la première couche de matériau sacrificiel 432 ceci de manière à encapsuler les premier et deuxième rubans d'isolation 313, 323, comme illustré sur la figure 3ZA,

- gravure localisée de la deuxième couche de matériau sacrificiel 432 pour former deux percées 452A, 452B débouchant respectivement sur le premier et le deuxième ruban d'isolation 313, 323, comme illustré sur la figure 3ZB,

- dépôt d'une couche destinée à former le revêtement barrière du troisième et du quatrième plot de connexion électrique 312, 322 en contact de la deuxième couche de matériau sacrificiel 432 et des parois des deux percées 452A, 452B qui y sont ménagées, ladite couche destinée à former le revêtement barrière pouvant être formée par un dépôt de nitrure de titane TiN, et dépôt du matériau destiné à former le cœur métallique des troisième et quatrième plots de connexion électrique 312, 322 de manière à remplir les deux percées 452A, 452B aménagées dans la deuxième couche de matériau sacrificiel 432 et de former les troisième et quatrième plots de connexion électrique 312, 322, comme illustré sur la figure 3ZC.

Cette première phase du procédé permet la formation d'un premier ensemble comprenant le premier substrat, le transistor 100 et une première partie des premier et deuxième bras d'isolation 310, 320.

La deuxième phase du procédé de fabrication selon l'invention peut être mise en œuvre avant, concomitamment, ou après la première phase décrite ci-dessus. La deuxième phase comprend les étapes suivantes :

- fourniture d'un deuxième substrat 341, le deuxième substrat 341 comprenant un circuit de lecture 340 et, sur une première surface du deuxième substrat 341 présentant un premier et un deuxième contact 325, 321 du circuit de lecture destinés à connecter respectivement à l'électrode de grille/première zone 111 et la deuxième zone 112, et une quatrième couche isolante 345, préférentiellement en dioxyde de silicium SiO$_2$, revêtant la partie de la première surface du deuxième substrat 340 en dehors du premier et du deuxième contact 325, 315 du circuit de lecture 341, ladite quatrième couche isolante recouvrant également la périphérie du premier et du deuxième contact 325, 315 du circuit de lecture 341, comme illustré sur la figure 4A,

- dépôt localisé d'un matériau réflecteur et conducteur en contact avec la première et la deuxième zone de contact 325, 315 et sur une partie de la quatrième couche isolante 345 pour former un troisième et un quatrième contact métallique 326, 316 et la surface de réflexion 330, le matériau réflecteur et conducteur, dans ce mode de réalisation de l'invention, étant sélectionné dans le groupe comportant l'aluminium Al, le cuivre Cu, l'or Au, le titane Ti, le platine Pt, le nickel Ni et leurs alliage dont notamment l'alliage de cuivre et d'aluminium avec une épaisseur comprise entre 100 nm et 1 μm, celle-ci étant préférentiellement égale à 300 nm, comme illustré sur la figure 4B,

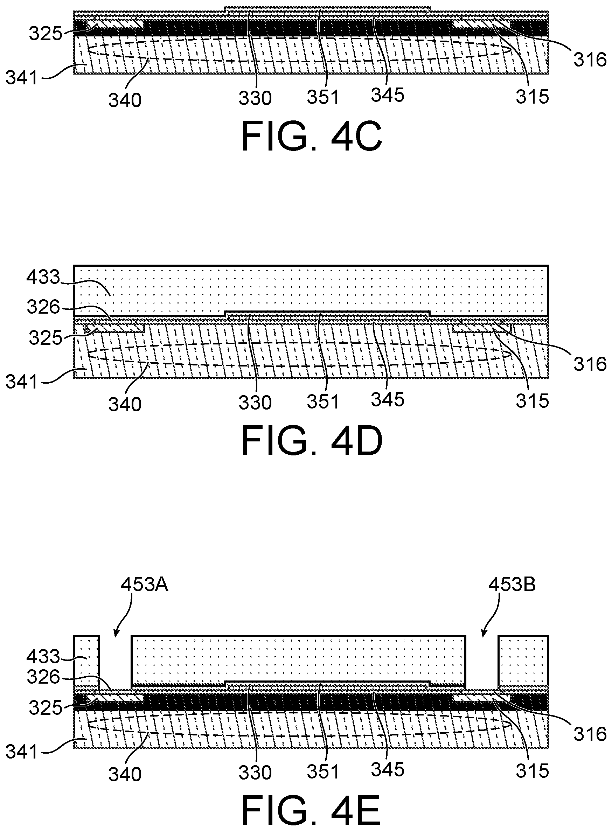

- dépôt d'une quatrième couche de protection 351 sur le premier substrat 340 en contact avec la surface de réflexion 330, les troisième et quatrième contacts métallique 326, 316 et la partie de la quatrième couche isolante 345 qui est libre de matériau réflecteur et conducteur, la quatrième couche de protection 351 étant préférentiellement choisie parmi une couche en nitrure d'aluminium AlN, de dioxyde d'hafnium HfO$_2$ ou de saphir Al$_2$O$_3$, apte à protéger lesdites couches lors d'une attaque acide telle qu'une attaque à l'acide fluorhydrique HF, ladite quatrième couche de protection 351 présentant une épaisseur comprise entre 10 et 50 nm et préférentiellement égale à 25 nm, comme illustré sur la figure 4C,

- dépôt d'une troisième couche de matériau sacrificiel 433, telle qu'une couche en dioxyde de silicium SiO$_2$, en contact avec la quatrième couche de protection 351 et étape de planarisation dudit matériau sacrificiel pour supprimer l'excès du deuxième matériau sacrificiel et fournir une couche du deuxième matériau sacrificiel comprise entre 1,3 et 2,5 μm, comme illustré sur la figure 4D,

- formation de deux percées 453A, 453B par gravure localisée de la troisième couche de matériau sacrificiel 433 et de la quatrième couche de protection 451, lesdites percées 453A, 453B débouchant sur le troisième et le quatrième contact métallique 326, 316, comme illustré sur la figure 4E,

- remplissage des percées 452A, 452B par un matériau métallique pour former le premier et le deuxième plot de connexion électrique, un deuxième ensemble à assembler comprenant le deuxième substrat 340, le matériau réflecteur et conducteur, le deuxième matériau sacrificiel 432 et les deuxièmes parties 310P, 320P du premier et du deuxième bras d'isolation thermique 310, 320, étant ainsi formé, comme illustré sur la figure 4F,

- collage du premier et du deuxième ensemble par leur face comprenant respectivement le premier et le deuxième matériau sacrificiel 431, 432, comme illustré sur la figure 4G,

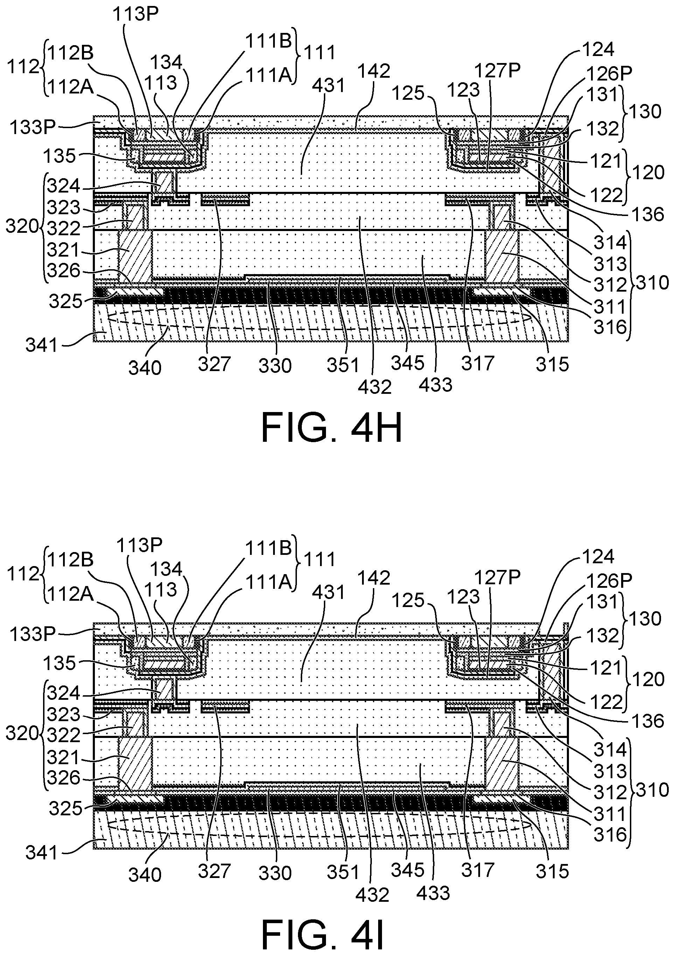

- suppression du premier substrat 410, comme illustré sur la figure 4H,

- gravure localisée de la troisième couche isolante 133 pour former une percée 454 débouchant sur la deuxième couche métallique 126, comme illustré sur la figure 4I,

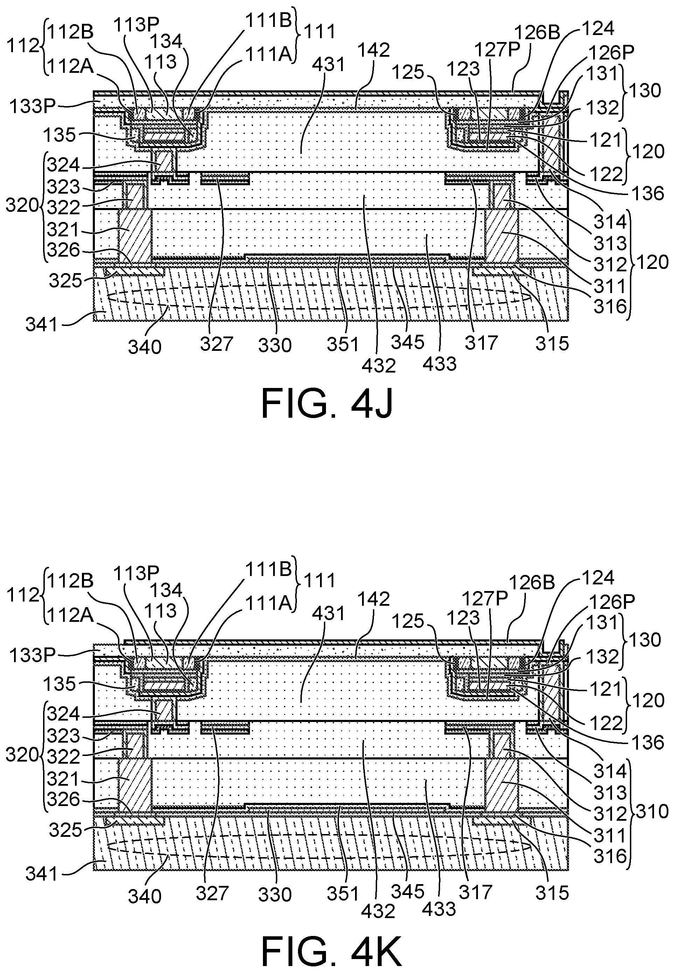

- dépôt de la troisième couche métallique 126B en contact avec la troisième couche isolante 133 et des parois de la percée qui y est ménagée, ladite troisième couche métallique 126B étant en contact avec la deuxième couche métallique 126 au travers de la percée ménagée dans la troisième couche isolante, comme illustré sur la figure 4J,

- gravure localisée de la troisième couche métallique 126B de manière à la délimiter latéralement, comme illustré sur la figure 4K,

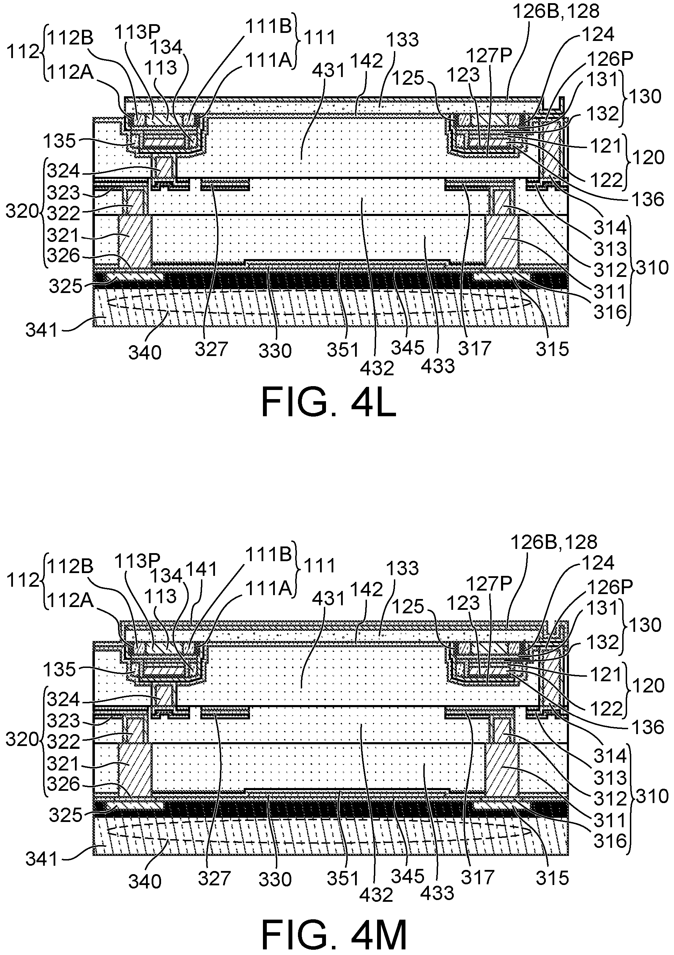

- gravure des parties de la troisième couche isolante 133 et des première et deuxième couches métalliques 127, 126, 126B qui ne sont pas recouvertes par la troisième couche métallique 126B, les parties de la deuxième couche de protection 142 qui ne sont pas en regard de la troisième couche métallique 126B étant ainsi mise à l'air, comme illustré sur la figure 4L,

- dépôt de la première couche de protection 141 en contact de la troisième couche métallique 126B et des parties de la deuxième couche de protection 142 mise à l'air, comme illustré sur la figure 4M,

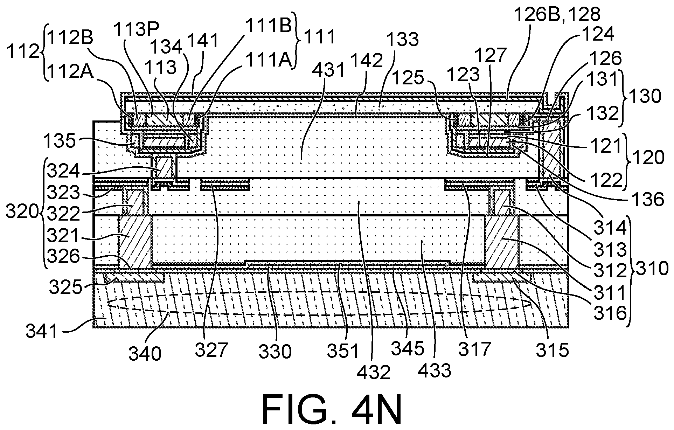

- gravure localisée des première et deuxième couches de protection 142, 142 de manière à délimiter latéralement la structure de détection 10, ladite gravure débouchant dans la première couche de matériau sacrificiel 431, comme illustré la figure 4N,

- suppression sélective des matériaux sacrificiels des première, deuxième et troisième couches de matériau sacrificiel 431, 432, 431, la structure de détection 10 selon l'invention étant ainsi formée et conforme à la figure 1.

On peut noter que, selon la possibilité selon laquelle la couche de masquage 122 est réalisée en un silicium polycristallin pSi non intentionnellement dopé, il est prévu préalablement, à l'étape de deuxième implantation, la formation d'une couche de protection préimplantatoire en contact de la couche de masquage, ceci pour prévenir toute implantation de cette dernière, une étape de retrait de cette couche de protection préimplantatoire étant alors mise en œuvre postérieurement à l'étape de deuxième implantation.

Selon une première variante, le procédé de fabrication peut ne pas comporter d'étape de gravure localisée de la première couche semiconductrice 113P de manière à garder uniquement les parties de la première couche semiconductrice 113P destinées à former les première, troisième et quatrième zones 111, 113, 112, la première couche semiconductrice étant alors gravée lors de l'étape de gravure sélective par rapport au $SiO_2$ et au SiN, des parties de la première couche semiconductrice 113P non protégées par l'ensemble première couche conductrice 121 /couche de masquage 122 et premier et deuxième élément d'extension latérale 134.

Selon une deuxième variante de l'invention particulièrement avantageuse, la structure 10 peut comporter un moyen de polarisation de la troisième zone 113, tel qu'un contact ohmique passant au travers de la troisième couche isolante.

Selon une troisième variante, la structure 10 peut ne pas comporter de troisième couche métallique 126B, la première couche métallique 127 comprenant une portion s'étendant en contact avec la troisième couche isolante 133 et formant l'élément absorbant 128. Conformément à cette variante, la deuxième couche métallique 127 présente préférentiellement la configuration décrite en lien avec la troisième couche métallique, à savoir qu'elle respecte, avec la troisième couche isolante 133 qui la supporte, les inégalités suivantes : 150 Ω ≤ p/Ep ≤ 700 Ω avec ρ la résistivité équivalente desdites couches et Ep la somme des épaisseurs desdites couches.

Un procédé de fabrication d'une structure selon cette variante se différencie en ce que lors de l'étape de gravure localisée de la couche métallique 126P, la deuxième couche métallique présente une portion s'étendant en contact de la troisième couche isolante 133P, ladite portion s'étendant au-delà de la première couche semiconductrice, comme illustré sur la figure 5 et en ce qu'il n'est pas prévu d'étapes en lien avec la troisième couche métallique 126B et notamment pas d'étape de dépôt de la troisième couche métallique 126B et de gravure de cette dernière.

Pour finir, on notera que si l'électrode de grille 120 comprend préférentiellement une première couche conductrice 121 réalisée dans un métal du type « mid-gap », il est également envisageable, sans que l'on sorte du cadre de l'invention, que la première couche conductrice soit réalisée en un autre métal qu'un métal « mid-gap ».

On notera que, comme déjà indiqué, la description du présent mode de réalisation permet d'illustrer le principe de l'invention et sa mise en œuvre. L'homme du métier est à même d'appliquer le concept de l'invention à d'autres structures de détection de l'art antérieur qui, du type bolomètre, utiliseraient un transistor en tant que transducteur. On notera ainsi, en particulier, que la configuration de l'élément d'absorption décrite dans le cadre du présent mode de réalisation n'est fourni qu'à titre d'exemple.

**Revendications**

1. Procédé de fabrication d'une structure de détection (10) de rayonnements électromagnétiques, ladite structure de détection (10) comprenant un transistor MOS (100) en tant que transducteur, le procédé comprenant les étapes suivantes :

   • fourniture d'une couche semiconductrice (113P) présentant une première concentration en porteurs majoritaires, ladite couche semiconductrice étant soit d'un type intrinsèque soit d'un premier type de conductivité,
   • dépôt d'au moins un premier matériau diélectrique à la surface de la couche semiconductrice pour former au moins une première couche isolante (131P),
   • dépôt d'un premier matériau conducteur en contact de l'au moins une première couche isolante (131P) pour former une première couche conductrice (121P),
   • dépôt d'une couche de masquage (122P) en contact de la première couche conductrice (121P),
   • gravure localisée de la couche de masquage (122P) et de la couche conductrice (121P) afin de former un ensemble couche de masquage/première couche conductrice, la première couche conductrice (121) ainsi gravée formant au moins en partie une électrode de grille (120) du transistor MOS (100) en recouvrant une première partie de la première couche semiconductrice (113P),
   • première implantation en éléments dopants de la couche semiconductrice (113P), la première partie de la couche semiconductrice (113P) étant protégée par l'ensemble couche de masquage/première couche conductrice, et ladite implantation étant réalisée avec une première dose adaptée pour fournir une deuxième concentration en porteurs majoritaires supérieure à la première concentration, lesdits éléments dopants étant aptes à fournir des porteurs majoritaires d'un type de conductivité donné,

• formation d'un premier et d'un deuxième élément d'extension latérale (134, 135, 136) réalisés dans au moins un matériau diélectrique en contact avec la première couche isolante (131P) de part et d'autre de l'ensemble couche de masquage/première couche conductrice et, lesdits premier et deuxième éléments d'extension latérale prolongeant l'ensemble couche de masquage/première couche conductrice à l'opposé l'un de l'autre,

• deuxième implantation en éléments dopants de la couche semiconductrice, une deuxième partie de la couche semiconductrice, comprenant la première partie de la couche semiconductrice, étant protégée par l'ensemble couche de masquage /première couche conductrice et les premier et deuxième éléments d'extension latérales qui les prolongent, ladite deuxième implantation étant réalisée avec une deuxième dose supérieure à la première dose et adaptée pour fournir une troisième concentration en porteurs majoritaires supérieure à la deuxième concentration, lesdits éléments dopants étant aptes à fournir des porteurs majoritaires du type de conductivité donné,

• recuit thermique de la couche semiconductrice, le recuit thermique étant apte à faire diffuser et à activer les éléments dopants implantés lors de la première et de la deuxième implantation, ceci de manière à former une première et deuxième zone (111, 112) du transistor avec pour chacune de la première et de la deuxième zone une première région (111A, 112A) présentant une concentration en porteurs majoritaires strictement supérieure à la deuxième concentration et une deuxième région (111B, 112B) présentant une concentration en porteurs majoritaires égale ou inférieure à la deuxième concentration, ladite première région (111A, 112A) étant respectivement en partie recouverte par les premier et deuxième élément d'extension latérale, lesdites première et deuxième zones (111, 112, 113) étant séparées l'une de l'autre par une troisième zone (113) du transistor recouverte par la première couche isolante,

• gravure localisée des parties de la couche semiconductrice (113P) non protégées par l'ensemble couche de masquage/première couche conductrice et les premier et deuxième éléments d'extension latérale qui les prolongent, ladite gravure sélective permettant de conserver uniquement les parties des premières régions (111A, 112A) de chacune de la première et de la deuxième zone (111, 112) protégées par les premier et deuxième éléments d'extension latérale (134, 135) et, le cas échéant, par l'ensemble couche de masquage/ première couche conductrice, ainsi une extrémité de chaque premier et deuxième élément d'extension latérale est alignée avec un flanc respectif de la couche semiconductrice (113P) selon une direction perpendiculaire à un plan de la couche semiconductrice (113P),

• dépôt d'au moins un deuxième matériau conducteur pour former un premier et un deuxième contact métallique, chacun du premier et deuxième contact métallique étant en contact avec la couche semiconductrice (113P) uniquement sur le flanc de gravure correspondant respectivement au premier et au deuxième élément d'extension latérale, au moins l'un du premier et du deuxième contact métallique (126, 126B, 127) formant un élément absorbant (128) s'étendant au-delà de la couche semiconductrice (113P), configuré pour absorber le rayonnement électromagnétique, le transistor MOS étant ainsi formé.

2. Procédé de fabrication d'une structure de détection (10) selon la revendication 1, dans lequel lors de l'étape de la formation d'une couche de masquage, la couche de masquage est réalisée dans un matériau au moins partiellement conducteur, et dans lequel l'électrode de grille est formée par la couche de masquage et l'au moins un premier matériau conducteur.

3. Procédé de fabrication d'une structure de détection (10) selon la revendication 2, dans lequel le matériau de la couche de masquage est un silicium polycristallin.

4. Procédé de fabrication d'une structure de détection (10) selon la revendication 1 dans lequel le matériau de la couche de masquage (122) est un silicium polycristallin non intentionnellement dopé, l'électrode de grille (122) étant formée par l'au moins un premier matériau conducteur et la couche de masquage (122) étant pourvue d'une ouverture afin d'autoriser la polarisation de l'électrode de grille (120).

5. Procédé de fabrication d'une structure de détection (10) selon l'une quelconque des revendications 1 à 4, comprenant en outre entre l'étape de gravure localisée des parties de la couche semiconductrice (113P) et l'étape de dépôt d'au moins un deuxième matériau conducteur, une étape de siliciuration des flancs de gravure correspondant respectivement au premier et au deuxième élément d'extension latérale.

6. Procédé de fabrication d'une structure de détection (10) selon l'une quelconque des revendications 1 à 5, dans lequel, après l'étape de gravure sélective des parties de la couche semiconductrice (113P) non protégées par l'ensemble couche de masquage/première couche conductrice et les premier et deuxième éléments d'extension latérale qui les prolongent, la couche semiconductrice (113P) entoure au moins en partie une zone d'un plan d'absorption défini par l'élément absorbant (128), l'élément absorbant (128) s'étendant au moins en partie sur ladite zone dudit plan d'absorption.

7. Procédé de fabrication d'une structure de détection (10) selon la revendication 6, dans lequel l'élément absorbant (128) comprend une couche métallique et est supporté par une couche diélectrique (133), le métal de la couche métallique de l'élément absorbant (128) et les épaisseurs de ladite couche et de la couche diélectrique le supportant étant choisies de manière à respecter les inégalités suivantes : $150\ \Omega \leq \rho/Ep \leq 700\ \Omega$ avec $\rho$ la résistivité équivalente desdites couches et Ep la somme des épaisseurs desdites couches.

8. Structure de détection (10) de rayonnements électromagnétiques, la structure comprenant un transistor MOS en tant que transducteur, le transistor MOS comprenant :

   • une première et une deuxième zone (111, 112) d'un deuxième type de conductivité et une troisième zone (113) d'un premier type de conductivité opposé au deuxième type de conductivité, la troisième zone (113) séparant l'une de l'autre les première et deuxième zones (111, 112), lesdites première, deuxième et troisième zones (111, 112, 113) étant aménagées dans une couche semiconductrice (113P), la troisième zone (113) présentant une première concentration en porteurs majoritaires et les première et deuxième zones (111, 112) présentant chacune une concentration en porteurs majoritaires supérieure à la première concentration en comportant une première région et une deuxième région, lesdites premières régions (111A, 112A) présentant une concentration en porteurs majoritaires strictement supérieure à une deuxième concentration en porteurs majoritaires et lesdites deuxièmes régions (111B, 112B) présentant une concentration en porteurs majoritaires égale ou inférieure à ladite deuxième concentration, ladite deuxième concentration étant supérieure à la première concentration,
   • au moins une première couche isolante (131) réalisée dans au moins un premier matériau diélectrique en contact avec la couche semiconductrice et recouvrant lesdites première, deuxième et troisième zones (111, 112, 113),
   • une première couche conductrice (121) réalisée dans un premier matériau conducteur en contact avec l'au moins une première couche isolante (132) et participant à la formation d'une électrode de grille du transistor MOS,
   • un premier et deuxième élément d'extension latérale (134, 135, 136) en matériau diélectrique en contact avec la couche isolante et prolongeant la première couche conductrice à l'opposé l'un de l'autre, lesdits premier et deuxième éléments d'extension latérale recouvrant au moins en partie les premières régions de la première et de la deuxième zone (111, 112) avec une extrémité de chaque premier et deuxième élément d'extension latérale alignée avec un flanc respectif de la couche semiconductrice (113P) selon une direction perpendiculaire à un plan de la couche semiconductrice (113P),
   • au moins un premier et un deuxième contact métallique, chacun du premier et du deuxième contact métallique étant en contact avec la couche semiconductrice (113P) uniquement sur le flanc de la couche semiconductrice (113P) correspondant respectivement au premier et au deuxième élément d'extension latérale, au moins l'un parmi le premier et le deuxième contact métallique formant un élément absorbant (128) configuré pour absorber le rayonnement électromagnétique,
   • la structure de détection étant telle que l'élément absorbant (128) s'étend selon un plan d'absorption perpendiculaire au flanc de la couche semiconductrice, avec une portion majoritaire de l'élément absorbant (128) qui est en dehors d'une projection de la couche semiconductrice (113P) sur le plan d'absorption.

9. Structure de détection (10) selon la revendication 8, comprenant en outre une couche de masquage (122) recouvrant la première couche conductrice.

10. Structure de détection (10) selon la revendication 9, dans laquelle le matériau de la couche de masquage (122) est un silicium polycristallin dopé, ladite couche de masquage (122) formant avec la première couche conductrice (121) une électrode de grille (120).

11. Structure de détection (10) selon la revendication 9, dans laquelle le matériau de la couche de masquage (122) est un silicium polycristallin non intentionnellement dopé, l'électrode de grille (122) étant formée par la première couche conductrice (121), et la couche de masquage (122) étant pourvue d'une ouverture afin d'autoriser la polarisation de l'électrode de grille (120).

12. Structure de détection (10) selon l'une quelconque des revendications 8 à 11, dans laquelle la couche semiconductrice (113P) entoure au moins en partie une zone d'un plan d'absorption défini par l'élément absorbant (128), l'élément absorbant (128) s'étendant au moins en partie sur ladite zone dudit plan d'absorption.

13. Structure de détection (10) selon l'une quelconque revendication 8 à 12, dans laquelle l'élément absorbant (128) comprend une couche métallique et est supporté par une couche diélectrique (133), le métal de la couche métallique de l'élément absorbant (128) et les épaisseurs de ladite couche et de la couche diélectrique le supportant étant choisies de manière à respecter les inégalités suivantes : $150\,\Omega \leq \rho/Ep \leq 700\,\Omega$ avec $\rho$ la résistivité équivalente desdites couches et $Ep$ la somme des épaisseurs desdites couches.

14. Structure de détection (10) selon l'une quelconque des revendications 8 à 13, dans laquelle la couche semiconductrice (113P) comporte sur chacun des flancs correspondant respectivement au premier et au deuxième élément d'extension latérale (134, 135, 136), une couche de contact (125, 124) formée d'un matériau siliciuré, ledit matériau étant préférentiellement sélectionné parmi le siliciure de nickel, le siliciure de titane, le siliciure de cobalt et le siliciure de platine.

## Patentansprüche

1. Verfahren zur Herstellung einer Detektionsstruktur (10) für elektromagnetische Strahlung, wobei die Detektionsstruktur (10) einen MOS-Transistor (100) als Wandler umfasst, wobei das Verfahren die folgenden Schritte umfasst:

   • Bereitstellung einer Halbleiterschicht (113P) mit einer ersten Konzentration an Majoritätsträgern, wobei die Halbleiterschicht entweder von einem intrinsischen Typ oder von einem ersten Leitfähigkeitstyp ist,
   • Ablagerung von mindestens einem ersten dielektrischen Material auf der Oberfläche der Halbleiterschicht, um mindestens eine erste Isolierschicht (131P) zu bilden,
   • Ablagerung eines ersten leitfähigen Materials in Kontakt mit der mindestens ersten Isolierschicht (131P), um eine erste leitfähige Schicht (121P) zu bilden,
   • Ablagerung einer Maskierungsschicht (122P) in Kontakt mit der ersten leitfähigen Schicht (121P),
   • lokalisiertes Ätzen der Maskierungsschicht (122P) und der leitfähigen Schicht (121P), um eine Baugruppe aus Maskierungsschicht/erster leitfähiger Schicht zu bilden, wobei die so geätzte erste leitfähige Schicht (121) mindestens teilweise eine Gitterelektrode (120) des MOS-Transistors (100) bildet, indem sie einen ersten Teil der ersten Halbleiterschicht (113P) abdeckt,
• erste Implantation von Dotierelementen der Halbleiterschicht (113P), wobei der erste Teil der Halbleiterschicht (113P) durch die Baugruppe aus Maskierungsschicht/erster leitfähiger Schicht geschützt ist, und wobei die Implantation mit einer ersten Dosis durchgeführt wird, die geeignet ist, eine zweite Konzentration an Majoritätsträgern zu liefern, die höher ist als die erste Konzentration, wobei die Dotierelemente in der Lage sind, Majoritätsträger eines gegebenen Leitfähigkeitstyps zu liefern,
• Bildung eines ersten und eines zweiten seitlichen Erweiterungselements (134, 135, 136), die aus mindestens einem dielektrischen Material in Kontakt mit der ersten Isolierschicht (131P) auf beiden Seiten der Baugruppe aus Maskierungsschicht/erster leitfähiger Schicht hergestellt sind, und wobei das erste und das zweite seitliche Erweiterungselement die Baugruppe aus Maskierungsschicht/erster leitfähiger Schicht auf der gegenüberliegenden Seite verlängern,
• zweite Implantation von Dotierelementen der Halbleiterschicht, wobei ein zweiter Teil der Halbleiterschicht, der den ersten Teil der Halbleiterschicht umfasst, durch die Baugruppe aus Maskierungsschicht/erster leitfähiger Schicht und das erste und das zweite seitliche Erweiterungselement, die sie verlängern, geschützt ist, wobei die zweite Implantation mit einer zweiten Dosis durchgeführt wird, die höher ist als die erste Dosis und geeignet ist, eine dritte Konzentration an Majoritätsträgern zu liefern, die höher ist als die zweite Konzentration, wobei die Dotierelemente in der Lage sind, Majoritätsträger des gegebenen Leitfähigkeitstyps zu liefern,
• thermisches Glühen der Halbleiterschicht, wobei das thermische Glühen dazu geeignet ist, die bei der ersten und zweiten Implantation implantierten Dotierelemente zu diffundieren und zu aktivieren, und zwar so, dass ein erster und ein zweiter Bereich (111, 112) des Transistors gebildet wird, wobei für jeden des ersten und des zweiten Bereichs eine erste Region (111A, 112A), die eine Konzentration an Majoritätsträgern aufweist, die strikt höher ist als die zweite Konzentration, und eine zweite Region (111B, 112B), die eine Konzentration an Majoritätsträgern aufweist, die gleich oder niedriger als die zweite Konzentration ist, vorgesehen ist, wobei die erste Region (111A, 112A) jeweils teilweise von dem ersten und dem zweiten seitlichen Erweiterungselement abdeckt ist, wobei der erste und der zweite Bereich (111, 112, 113) durch einen dritten Bereich (113) des Transistors, der von der ersten Isolierschicht abdeckt ist, voneinander getrennt sind,

• lokalisiertes Ätzen der Teile der Halbleiterschicht (113P), die nicht durch die Baugruppe aus Maskierungsschicht/erster leitfähiger Schicht und das erste und das zweite seitliche Erweiterungselement, die sie verlängern, geschützt sind, wobei das selektive Ätzen es ermöglicht, nur die Teile der ersten Regionen (111A, 112A) jedes des ersten und des zweiten Bereichs (111, 112) zu erhalten, die durch das erste und das zweite seitliche Erweiterungselement (134, 135) und gegebenenfalls durch die Baugruppe aus Maskierungsschicht/erster leitfähiger Schicht geschützt sind, so dass ein Ende jedes ersten und zweiten seitlichen Erweiterungselements mit einer jeweiligen Flanke der Halbleiterschicht (113P) in einer Richtung senkrecht zu einer Ebene der Halbleiterschicht (113P) ausgerichtet ist,

• Ablagerung von mindestens einem zweiten leitfähigen Material, um einen ersten und einen zweiten Metallkontakt zu bilden, wobei jeder des ersten und des zweiten Metallkontakts nur auf der Ätzflanke, die jeweils dem ersten und dem zweiten seitlichen Erweiterungselement entspricht, mit der Halbleiterschicht (113P) in Kontakt steht, wobei mindestens einer des ersten und des zweiten Metallkontakts (126, 126B, 127) ein absorbierendes Element (128) bildet, das sich über die Halbleiterschicht (113P) hinaus erstreckt und dazu konfiguriert ist, die elektromagnetische Strahlung zu absorbieren, wodurch der MOS-Transistor gebildet wird.

2. Verfahren zur Herstellung einer Detektionsstruktur (10) nach Anspruch 1, wobei bei dem Schritt der Bildung einer Maskierungsschicht, die Maskierungsschicht aus einem mindestens teilweise leitfähigen Material hergestellt wird, und wobei die Gitterelektrode durch die Maskierungsschicht und das mindestens eine erste leitfähige Material gebildet wird.

3. Verfahren zur Herstellung einer Detektionsstruktur (10) nach Anspruch 2, wobei das Material der Maskierungsschicht ein polykristallines Silizium ist.

4. Verfahren zur Herstellung einer Detektionsstruktur (10) nach Anspruch 1, wobei das Material der Maskierungsschicht (122) ein nicht absichtlich dotiertes polykristallines Silizium ist, wobei die Gitterelektrode (122) aus dem mindestens einen ersten leitfähigen Material gebildet wird und die Maskierungsschicht (122) mit einer Öffnung versehen ist, um die Polarisation der Gitterelektrode (120) zu ermöglichen.

5. Verfahren zur Herstellung einer Detektionsstruktur (10) nach einem der Ansprüche 1 bis 4, ferner umfassend zwischen dem Schritt des lokalisierten Ätzens der Teile der Halbleiterschicht (113P) und dem Schritt der Ablagerung von mindestens einem zweiten leitfähigen Material einen Schritt der Silizidierung der Ätzflanken, die jeweils dem ersten und dem zweiten seitlichen Erweiterungselement entsprechen.

6. Verfahren zur Herstellung einer Detektionsstruktur (10) nach einem der Ansprüche 1 bis 5, wobei nach dem Schritt des selektiven Ätzens der Teile der Halbleiterschicht (113P), die nicht durch die Baugruppe aus Maskierungsschicht/erster leitfähiger Schicht und das erste und das zweite seitliche Erweiterungselement, die sie verlängern, geschützt sind, die Halbleiterschicht (113P) mindestens teilweise einen Bereich einer durch das absorbierende Element (128) definierten Absorptionsebene umgibt, wobei sich das absorbierende Element (128) mindestens teilweise über den Bereich der Absorptionsebene erstreckt.

7. Verfahren zur Herstellung einer Detektionsstruktur (10) nach Anspruch 6, wobei das absorbierende Element (128) eine Metallschicht umfasst und von einer dielektrischen Schicht (133) getragen wird, wobei das Metall der Metallschicht des absorbierenden Elements (128) und die Dicken der Schicht und der dielektrischen Schicht so gewählt sind, dass die folgenden Ungleichheiten eingehalten werden: $150\,\Omega \leq p/Ep \leq 700\,\Omega$ mit $\rho$ dem äquivalenten Widerstand der Schichten und $Ep$ der Summe der Dicke der Schichten.

8. Detektionsstruktur (10) für elektromagnetische Strahlung, wobei die Struktur einen MOS-Transistor als Wandler umfasst, wobei der MOS-Transistor Folgendes umfasst:

• einen ersten und einen zweiten Bereich (111, 112) einer zweiten Leitfähigkeitsart und einen dritten Bereich (113) eines ersten Leitfähigkeitstyps, der dem zweiten Leitfähigkeitstyp entgegengesetzt ist, wobei der dritte Bereich (113) den ersten und den zweiten Bereich (111, 112) voneinander trennt, wobei der erste, der zweite und der dritte Bereich (111, 112, 113) in einer Halbleiterschicht (113P) angeordnet sind, wobei der dritte Bereich (113) eine erste Konzentration an Majoritätsträgern aufweist und der erste und der zweite Bereich (111, 112) jeweils eine Konzentration an Majoritätsträgern aufweisen, die höher ist als die erste Konzentration, indem sie eine erste Region und eine zweite Region umfassen, wobei die ersten Regionen (111A, 112A) eine Konzentration an Majoritätsträgern aufweisen, die strikt höher ist als eine zweite Konzentration an Majoritätsträgern, und die zweiten Regionen (111B, 112B) eine Konzentration an Majoritätsträgern aufweisen, die gleich oder niedriger ist als die zweite Konzentration, wobei die zweite Konzentration höher ist als die erste Konzentration,

• mindestens eine erste Isolierschicht (131), die aus mindestens einem ersten dielektrischen Material hergestellt ist, das mit der Halbleiterschicht in Kontakt steht und die ersten, zweiten und dritten Bereiche (111, 112, 113) abdeckt,

• eine erste leitfähige Schicht (121), die aus einem ersten leitfähigen Material hergestellt ist, das mit der mindestens ersten Isolierschicht (132) in Kontakt steht und an der Bildung einer Gitterelektrode des MOS-Transistors teilnimmt,

• ein erstes und ein zweites seitliches Erweiterungselement (134, 135, 136) aus dielektrischem Material, die in Kontakt mit der Isolierschicht stehen und die erste leitfähige Schicht einander gegenüberliegend verlängert, wobei das erste und das zweite seitliche Erweiterungselement die ersten Regionen des ersten und des zweiten Bereichs (111, 112) mindestens teilweise abdecken, wobei ein Ende jedes ersten und zweiten seitlichen Erweiterungselements mit einer jeweiligen Flanke der Halbleiterschicht (113P) in einer Richtung senkrecht zu einer Ebene der Halbleiterschicht (113P) ausgerichtet ist,

• mindestens einen ersten und einen zweiten Metallkontakt, wobei jeder des ersten und des zweiten Metallkontakts nur an der Flanke der Halbleiterschicht (113P) in Kontakt mit der Halbleiterschicht (113P) ist, die jeweils dem ersten und zweiten seitlichen Erweiterungselement entspricht, wobei mindestens einer des ersten und des zweiten Metallkontakt ein absorbierendes Element (128) bildet, das dazu konfiguriert ist, die elektromagnetische Strahlung zu absorbieren,

• wobei die Detektionsstruktur so ist, dass sich das absorbierende Element (128) in einer Absorptionsebene senkrecht zur Flanke der Halbleiterschicht erstreckt, wobei sich ein mehrheitlicher Teil des absorbierenden Elements (128) außerhalb einer Projektion der Halbleiterschicht (113P) auf der Absorptionsebene befindet.

9. Detektionsstruktur (10) nach Anspruch 8, ferner umfassend eine Maskierungsschicht (122), die die erste leitfähige Schicht abdeckt.

10. Detektionsstruktur (10) nach Anspruch 9, wobei das Material der Maskierungsschicht (122) ein dotiertes polykristallines Silizium ist, wobei die Maskierungsschicht (122) mit der ersten leitfähigen Schicht (121) eine Gitterelektrode (120) bildet.

11. Detektionsstruktur (10) nach Anspruch 9, wobei das Material der Maskierungsschicht (122) ein nicht absichtlich dotiertes polykristallines Silizium ist, wobei die Gitterelektrode (122) von der ersten leitfähigen Schicht (121) gebildet wird und die Maskierungsschicht (122) mit einer Öffnung versehen ist, um die Polarisation der Gitterelektrode (120) zu ermöglichen.

12. Detektionsstruktur (10) nach einem der Ansprüche 8 bis 11, wobei die Halbleiterschicht (113P) mindestens teilweise einen Bereich einer durch das absorbierende Element (128) definierten Absorptionsebene umgibt, wobei sich das absorbierende Element (128) mindestens teilweise über den Bereich der Absorptionsebene erstreckt.

13. Detektionsstruktur (10) nach einem der Ansprüche 8 bis 12, wobei das absorbierende Element (128) eine Metallschicht umfasst und von einer dielektrischen Schicht (133) getragen wird, wobei das Metall der Metallschicht des absorbierenden Elements (128) und die Dicken der Schicht und der sie tragenden dielektrischen Schicht so gewählt werden, dass die folgenden Ungleichheiten eingehalten werden: $150\,\Omega \leq \rho/Ep \leq 700\,\Omega$ mit $\rho$ dem äquivalenten Widerstand der Schichten und Ep der Summe der Dicke der Schichten.

14. Detektionsstruktur (10) nach einem der Ansprüche 8 bis 13, wobei die Halbleiterschicht (113P) an jeder der Flanken, die jeweils dem ersten und dem zweiten seitlichen Erweiterungselement (134, 135, 136) entsprechen, eine Kontaktschicht (125, 124) umfasst, die aus einem silizidierten Material gebildet ist, wobei das Material bevorzugt aus Nickelsilizid, Titansilizid, Kobaltsilizid und Platinsilizid ausgewählt ist.

**Claims**

1. A method for manufacturing an electromagnetic radiation detection structure (10), said detection structure (10) comprising a MOS transistor (100) as a transducer, the method comprising the following steps:

• providing a semiconductor layer (113P) having a first concentration of majority carriers, said semiconductor layer being either of an intrinsic type or of a first conductivity type,
• depositing at least one first dielectric material on the surface of the semiconductor layer to form at least one first insulating layer (131P),
• depositing a first conductive material in contact with the at least one first insulating layer (131P) to form a first conductive layer (121P),

• depositing a masking layer (122P) in contact with the first conductive layer (121P),

• localised etching of the masking layer (122P) and the conductive layer (121P) in order to form a masking layer/first conductive layer assembly, the first conductive layer (121) thus etched forming at least partially a gate electrode (120) of the MOS transistor (100) by covering a first portion of the first semiconductor layer (113P),

• first dopant elements implantation of the semiconductor layer (113P), the first part of the semiconductor layer (113P) being protected by the masking layer/first conductive layer assembly, and said implantation being carried out with a first dose adapted to provide a second concentration of majority carriers greater than the first concentration, said dopant elements being capable of providing majority carriers of a given conductivity type,

• forming a first and a second lateral extension element (134, 135, 136) made of at least one dielectric material in contact with the first insulating layer (131P) on either side of the masking layer/first conductive layer assembly and, said first and second lateral extension elements extending on opposite sides of the masking layer/first conductive layer assembly,

• second dopant element implantation of the semiconductor layer, a second part of the semiconductor layer, comprising the first part of the semiconductor layer, being protected by the masking layer/first conductive layer assembly and the first and second lateral extension elements extending them, said second implantation being carried out with a second dose greater than the first dose and adapted to provide a third concentration of majority carriers greater than the second concentration, said dopants being capable of providing majority carriers of the given conductivity type,

• thermally annealing the semiconductor layer, the thermal annealing being capable of diffusing and activating the dopant elements implanted during the first and second implantation, so as to form a first and second zone (111, 112) of the transistor with for each of the first and second zone a first region (111A, 112A) having a concentration of majority carriers strictly greater than the second concentration and a second region (111B, 112B) having a concentration of majority carriers equal to or less than the second concentration, said first region (111A, 112A) being respectively partially covered by the first and second lateral extension elements, said first and second zones (111, 112, 113) being separated from each other by a third zone (113) of the transistor covered by the first insulating layer,

• localised etching of the parts of the semiconductor layer (113P) not protected by the masking layer/first conductive layer assembly and the first and second lateral extension elements extending them, said selective etching making it possible to retain only the parts of the first regions (111A, 112A) of each of the first and second zones (111, 112) protected by the first and second lateral extension elements (134, 135) and, where applicable, by the masking layer/first conductive layer assembly, thus one end of each first and second lateral extension element is aligned with a respective flank of the semiconductor layer (113P) in a direction perpendicular to a plane of the semiconductor layer (113P),

• depositing at least one second conductive material to form a first and second metal contact, each of the first and second metal contact being in contact with the semiconductor layer (113P) only on the etching flank corresponding respectively to the first and second lateral extension element, at least one of the first and second metal contact (126, 126B, 127) forming an absorbing element (128) extending beyond the semiconductor layer (113P), configured to absorb the electromagnetic radiation, the MOS transistor being thus formed.

2. The method for manufacturing a detection structure (10) according to claim 1, wherein during the step of forming a masking layer, the masking layer is made of an at least partially conductive material, and wherein the gate electrode is formed by the masking layer and the at least one first conductive material.

3. The method for manufacturing a detection structure (10) according to claim 2, wherein the material of the masking layer is a polycrystalline silicon.

4. The method for manufacturing a detection structure (10) according to claim 1 wherein the material of the masking layer (122) is an unintentionally doped polycrystalline silicon, the gate electrode (122) being formed by the at least one first conductive material and the masking layer (122) being provided with an opening in order to allow polarisation of the gate electrode (120).

5. The method for manufacturing a detection structure (10) according to any one of claims 1 to 4, further comprising between the step of localised etching of the parts of the semiconductor layer (113P) and the step of depositing at least one second conductive material, a step of silicidising the etching flanks corresponding respectively to the first and second lateral extension element.

6. The method for manufacturing a detection structure (10) according to any one of claims 1 to 5, wherein, after the step of selectively etching the parts of the semiconductor layer (113P) not protected by the masking layer/first conductive layer assembly and the first and second lateral extension elements extending them, the semiconductor layer (113P) at least partially surrounds a zone of an absorption plane defined by the absorbing element (128), the absorbing element (128) extending at least partially over said zone of said absorption plane.

7. The method for manufacturing a detection structure (10) according to claim 6, wherein the absorbing element (128) comprises a metal layer and is supported by a dielectric layer (133), the metal of the metal layer of the absorbing element (128) and the thicknesses of said layer and of the dielectric layer supporting it being selected so as to comply with the following inequalities: $150\,\Omega \leq \rho/Ep \leq 700\,\Omega$ with $\rho$ the equivalent resistivity of said layers and Ep the sum of the thicknesses of said layers.

8. An electromagnetic radiation detection structure (10), the structure comprising a MOS transistor as a transducer, the MOS transistor comprising:

• first and second zones (111, 112) of a second conductivity type and a third zone (113) of a first conductivity type opposite to the second conductivity type, the third zone (113) separating the first and second zones (111, 112) from each other, said first, second and third zones (111, 112, 113) being formed in a semiconductor layer (113P), the third zone (113) having a first concentration of majority carriers and each of the first and second zones (111, 112) having a concentration of majority carriers higher than the first concentration comprising a first region and a second region, said first regions (111A, 112A) having a concentration of majority carriers strictly higher than a second concentration of majority carriers and said second regions (111B, 112B) having a concentration of majority carriers equal to or lower than said second concentration, said second concentration being higher than the first concentration,
• at least one first insulating layer (131) made of at least one first dielectric material in contact with the semiconductor layer and covering said first, second and third zones (111, 112, 113),
• a first conductive layer (121) made of a first conductive material in contact with the at least one first insulating layer (132) and participating in the formation of a gate electrode of the MOS transistor,
• a first and second lateral extension element (134, 135, 136) made of dielectric material in contact with the insulating layer and extending on opposite sides of the first conductive layer, said first and second lateral extension elements at least partially covering the first regions of the first and second zone (111, 112) with one end of each first and second lateral extension element aligned with a respective flank of the semiconductor layer (113P) in a direction perpendicular to a plane of the semiconductor layer (113P),
• at least one first and one second metal contact, each of the first and second metal contact being in contact with the semiconductor layer (113P) only on the flank of the semiconductor layer (113P) corresponding respectively to the first and second lateral extension element, at least one of the first and second metal contact forming an absorbing element (128) configured to absorb the electromagnetic radiation,
• the detection structure being such that the absorbing element (128) extends according to an absorption plane perpendicular to the flank of the semiconductor layer, with a majority portion of the absorbing element (128) which is outside a projection of the semiconductor layer (113P) onto the absorption plane.

9. The detection structure (10) according to claim 8, further comprising a masking layer (122) covering the first conductive layer.

10. The detection structure (10) according to claim 9, wherein the material of the masking layer (122) is a doped polycrystalline silicon, said masking layer (122) forming, with the first conductive layer (121), a gate electrode (120).

11. The detection structure (10) according to claim 9, wherein the material of the masking layer (122) is an unintentionally doped polycrystalline silicon, the gate electrode (122) being formed by the first conductive layer (121), and the masking layer (122) being provided with an opening in order to allow polarisation of the gate electrode (120).

12. The detection structure (10) according to any one of claims 8 to 11, wherein the semiconductor layer (113P) at least partially surrounds a zone of an absorption plane defined by the absorbing element (128), the absorbing element (128) extending at least partially over said zone of said absorption plane.

13. The detection structure (10) according to any one of claims 8 to 12, wherein the absorbing element (128) comprises a metal layer and is supported by a dielectric layer (133), the metal of the metal layer of the absorbing element (128) and the thicknesses of said layer and of the dielectric layer supporting it being selected so as to comply with the following inequal-

ities: 150 $\Omega \leq \rho/Ep \leq 700\ \Omega$ with $\rho$ the equivalent resistivity of said layers and Ep the sum of the thicknesses of said layers.

14. The detection structure (10) according to any one of claims 8 to 13, wherein the semiconductor layer (113P) comprises on each of the flanks corresponding respectively to the first and second lateral extension element (134, 135, 136), a contact layer (125, 124) formed of a silicidised material, said material being preferably selected from among nickel silicide, titanium silicide, cobalt silicide and platinum silicide.

FIG. 1

FIG. 2A

FIG. 2B

FIG. 5

113P
133P
410

FIG. 3A

113P
133P
410

FIG. 3B

131P
113P
133P
410

FIG. 3C

132P
131P
113P
133P
410

FIG. 3D

121P    132P
131P
113P
133P
410

FIG. 3E

FIG. 3F

FIG. 3G

FIG. 3H

FIG. 3I

FIG. 3J

FIG. 3K

FIG. 3L

FIG. 3M

FIG. 3N

FIG. 3O

FIG. 3P

EP 3 874 247 B1

FIG. 3Q

FIG. 3R

FIG. 3S

29

FIG. 3T

FIG. 3U

FIG. 3V

FIG. 3W

FIG. 3X

FIG. 3Y

FIG. 3Z

FIG. 3ZA

FIG. 3ZB

FIG. 3ZC

FIG. 4A

FIG. 4B

34

**FIG. 4C**

**FIG. 4D**

**FIG. 4E**

FIG. 4F

FIG. 4G

FIG. 4H

FIG. 4I

FIG. 4J

FIG. 4K

FIG. 4L

FIG. 4M

FIG. 4N

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018055276 A1
- CN 103050412 B

- DE 2909320
- WO 2018055276 A